# EUROPEAN PATENT APPLICATION

(11) **EP 4 852 640 A1**
(43) Date of publication of application: **09.12.2026**
(21) Application number: 26700296.2
(22) Date of filing: 02.01.2026
(51) Int. Cl.: H05K 7/20, H04M 1/02

(54) **ELECTRONIC DEVICE INCLUDING HEAT DISSIPATION MEMBER**

(30) Priority: 31.03.2025 KR 20250041819; 07.07.2025 KR 20250091194
(71) Applicant: Samsung Electronics Co., Ltd, Suwon-si, Gyeonggi-do 16677 (KR)
(72) Inventor: LEE, Sungbok, Suwon-si, Gyeonggi-do 16677 (KR); HUH, Jaeyoung, Suwon-si, Gyeonggi-do 16677 (KR); JEONG, Chihwan, Suwon-si, Gyeonggi-do 16677 (KR); JUNG, Dongkee, Suwon-si, Gyeonggi-do 16677 (KR); LEE, Howon, Suwon-si, Gyeonggi-do 16677 (KR); LEE, Kyuhwan, Suwon-si, Gyeonggi-do 16677 (KR); MIN, Seongjae, Suwon-si, Gyeonggi-do 16677 (KR); KIM, Junkyeom, Suwon-si, Gyeonggi-do 16677 (KR); KIM, Kuntak, Suwon-si, Gyeonggi-do 16677 (KR); KWON, Kihwan, Suwon-si, Gyeonggi-do 16677 (KR); KANG, Dongku, Suwon-si, Gyeonggi-do 16677 (KR)
(74) Representative: HGF
(86) International application number: PCT/KR2026/000077
(87) International publication number: WO 2026/212119

(57) **Abstract**

An electronic device is disclosed. The electronic device includes a heat dissipation member positioned between a bendable portion of a flexible display and a hinge assembly, and including a thermal diffusion member. The heat dissipation member includes a first heat dissipation member portion overlapping a first hinge plate of the hinge assembly and attached fixedly to the first hinge plate, and a second heat dissipation member portion overlapping a second hinge plate of the hinge assembly and movable relative to the second hinge plate when the first housing part is rotated relative to the second housing part. A first width of the thermal diffusion member within the first heat dissipation member portion in a direction perpendicular to a folding axis of the hinge assembly is greater than a second width of the thermal diffusion member within the second heat dissipation member portion in the direction.

## Description

### [Technical Field]

The following description relates to an electronic device including a heat dissipation member.

### [Background Art]

An electronic device may include housing parts and a flexible display that are rotatably coupled. As the housing parts rotate, a portion of the flexible display may be bent. The electronic device may include a cushion for protecting the flexible display. The cushion may be disposed under the flexible display.

The electronic device may include electronic components for providing various functions of the electronic device. When the electronic components operate, heat may be caused from the electronic components. In order to dissipate the heat caused from the electronic components, the electronic device may include a heat dissipation sheet.

The above-described information may be provided as a related art for a purpose of helping understanding of the present disclosure. No claim or determination is raised as to whether any of the above-described descriptions may be applied as a prior art related to the present disclosure.

### [Disclosure]

### [Technical Solution]

An electronic device is disclosed. The electronic device may include a housing. The housing may include a first housing part and a second housing part. The electronic device may include a flexible display including a bendable portion configured to bend when the first housing part is rotated relative to the second housing part. The electronic device may include a hinge assembly disposed under the flexible display and rotatably connecting the first housing part and the second housing part such that the first housing part is rotated relative to the second housing part. The hinge assembly may include a first hinge plate, and a second hinge plate, with the first hinge plate, configured to bend the bendable portion into a specified shape. The electronic device may include a heat dissipation member positioned between the bendable portion and the hinge assembly, and including a thermal diffusion member. The heat dissipation member may include a first heat dissipation member portion overlapping the first hinge plate and attached fixedly to the first hinge plate, and a second heat dissipation member portion overlapping the second hinge plate and movable relative to the second hinge plate when the first housing part is rotated relative to the second housing part. A first width of the thermal diffusion member within the first heat dissipation member portion in a direction perpendicular to a folding axis of the hinge assembly may be greater than a second width of the thermal diffusion member within the second heat dissipation member portion in the direction.

An electronic device is disclosed. The electronic device may include a flexible display. The electronic device may include a foldable housing accommodating the flexible display. The foldable housing may include a first housing part and a second housing part. The electronic device may include a hinge assembly rotatably connecting each of the first housing part and the second housing part. The hinge assembly may include a first hinge plate connected to the first housing part, a second hinge plate connected to the second housing part, and a hinge module rotatably connected to each of the first housing part and the second housing part. The electronic device may include a heat dissipation member extending over the first hinge plate, the hinge module, and the second hinge plate. The heat dissipation member may be adhesively fixed to the first hinge plate and disposed in order not to be adhered to the second hinge plate.

A foldable electronic device is disclosed. The foldable electronic device may include a housing. The housing may include a first housing part and a second housing part. The foldable electronic device may include a flexible display disposed on the housing. The flexible display may include a bendable portion configured to bend when the first housing part is rotated relative to the second housing part. The foldable electronic device may include a hinge assembly rotatably connecting the first housing part and the second housing part. The hinge assembly may include a first hinge plate connected to the first housing part, a second hinge plate connected to the second housing part. The foldable electronic device may include a heat dissipation member positioned between the bendable portion and the hinge assembly. The heat dissipation member may include a thermal diffusion member, a first heat dissipation member portion disposed to overlap the first hinge plate, and a second heat dissipation member portion disposed to overlap the second hinge plate. The thermal diffusion member may include a first thermal diffusion member portion corresponding to the first heat dissipation member portion and a second thermal diffusion member portion corresponding to the second heat dissipation member portion. A first width of the first thermal diffusion member portion in a direction perpendicular to a folding axis of the hinge assembly and parallel to the surface of the thermal diffusion member may be greater than a second width of the second thermal diffusion member portion in the direction.

### [Description of the Drawings]

FIG. 1 is a block diagram of an electronic device in a network environment according to various embodiments.
FIG. 2A illustrates an example of an unfolded state of an electronic device according to an embodiment.
FIG. 2B illustrates an example of a folded state of an electronic device according to an embodiment.
FIG. 2C is an exploded view of an electronic device according to an embodiment.
FIG. 3A illustrates an interior of an electronic device according to an embodiment.
FIG. 3B is a cross-sectional view in which the electronic device of FIG. 3A is cut along line A-A'.
FIG. 3C is an exploded view of an electronic device according to an embodiment.
FIG. 4 is a cross-sectional view in which the electronic device of FIG. 3A is cut along line B-B'.
FIG. 5 illustrates a structure of a heat dissipation sheet according to an embodiment.
FIG. 6A is a cross-sectional view of an electronic device according to an embodiment.
FIGS. 6B and 6C are a perspective view of an electronic device according to an embodiment.
FIG. 7 illustrates a structure of a heat dissipation sheet according to an embodiment.
FIG. 8 illustrates a heat dissipation sheet attached to a hinge assembly, according to an embodiment.
FIG. 9 illustrates a state in which a hinge assembly to which a heat dissipation sheet is attached is folded, according to an embodiment.
FIG. 10 illustrates a heat dissipation sheet according to an embodiment.
FIG. 11 illustrates an interior of an electronic device according to an embodiment.
FIG. 12A illustrates an exemplary electronic device in a first state.
FIG. 12B illustrates an exemplary electronic device in a second state.
FIG. 12C is a plan view of an exemplary electronic device in a first state from which a flexible display is removed.

### [Mode for Invention]

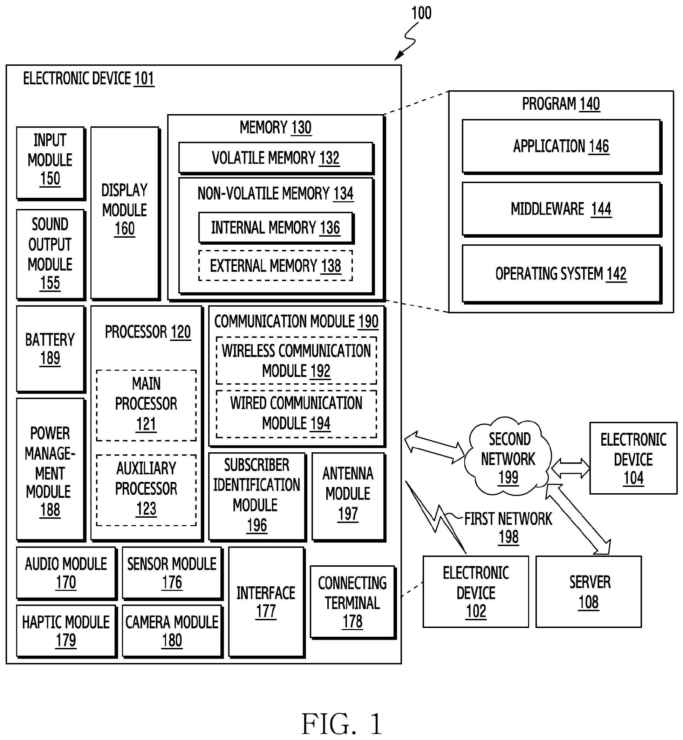

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

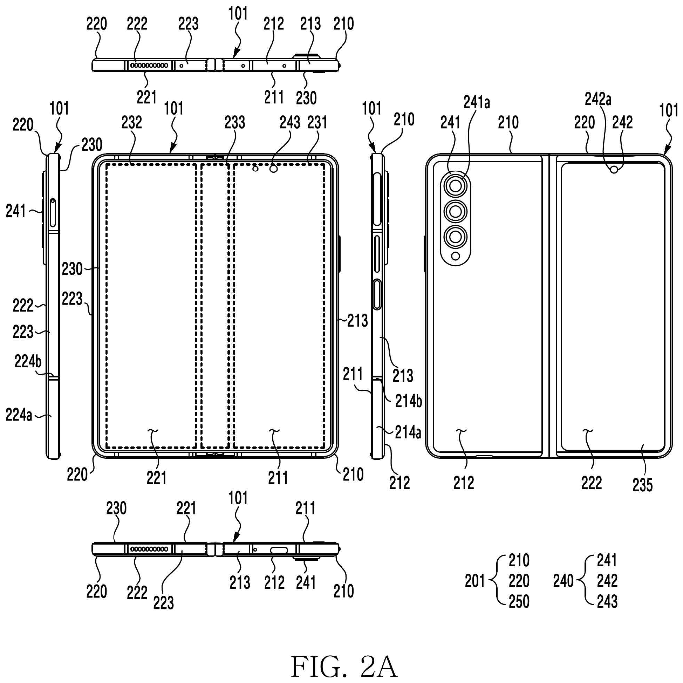

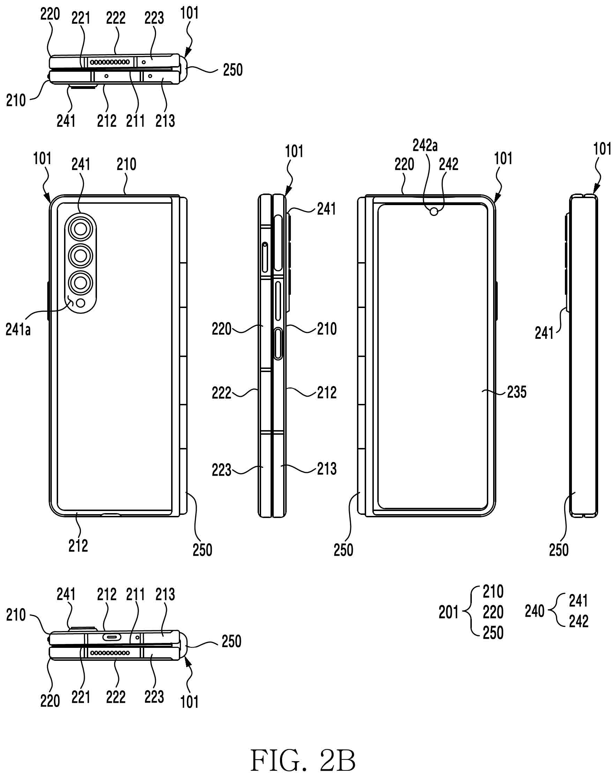

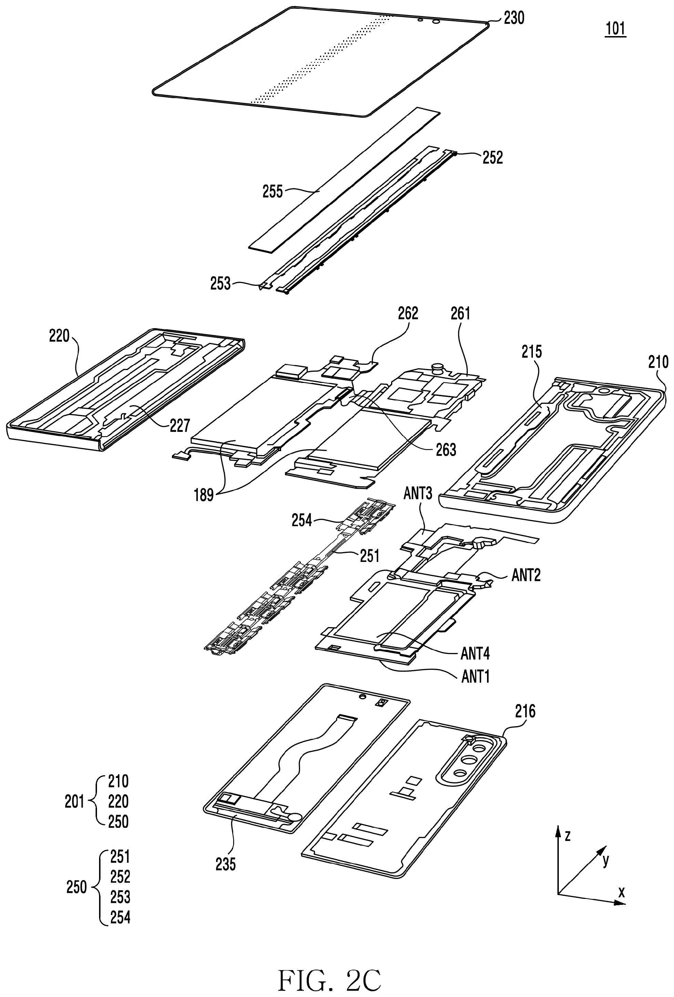

FIG. 2A illustrates an example of an unfolded state of an electronic device according to an embodiment. FIG. 2B illustrates an example of a folded state of an electronic device according to an embodiment. FIG. 2C is an exploded view of an electronic device according to an embodiment.

Referring to FIGS. 2A, 2B, and 2C, an electronic device 101 according to an embodiment may include a foldable housing 201, a display 230 (e.g., the display module 160 of FIG. 1), or one or more cameras 240.

According to an embodiment, the foldable housing 201 may define an exterior of the electronic device 101. For example, the foldable housing 201 may accommodate components disposed inside the electronic device 101 as a physical exterior of the electronic device 101 exposed to the outside. At least some of the components for implementing a function of the electronic device 101 may be disposed in the foldable housing 201. According to an embodiment, the foldable housing 201 may include a first housing part 210, a second housing part 220, and a hinge assembly 250.

According to an embodiment, the first housing part 210 may include a first surface 211, a second surface 212 opposite to the first surface 211, and a first side surface 213 at least partially covering a periphery of the first surface 211 and a periphery of the second surface 212. For example, the first surface 211 may be referred to as a front surface of the first housing part 210, and the second surface 212 may be referred to as a rear surface of the first housing part 210. The first side surface 213 may be connected to the periphery of the first surface 211 and the periphery of the second surface 212. The first surface 211, the second surface 212, and the first side surface 213 may form an inner space of the first housing part 210. For example, at least one component may be disposed in a space covered by the first surface 211, the second surface 212, and the first side surface 213.

According to an embodiment, the second housing part 220 may include a third surface 221, a fourth surface 222 opposite to the third surface 221, and a second side surface 223 at least partially covering a periphery of the third surface 221 and a periphery of the fourth surface 222. For example, the third surface 221 may be referred to as a front surface of the second housing part 220, and the fourth surface 222 may be referred to as a rear surface of the second housing part 220. The second side surface 223 may be connected to the periphery of the third surface 221 and the periphery of the fourth surface 222. The third surface 221, the fourth surface 222, and the second side surface 223 may form an inner space of the second housing part 220. For example, at least one component may be disposed in a space covered by the third surface 221, the fourth surface 222, and the second side surface 223.

According to an embodiment, the display 230 may be configured to display visual information. For example, the display 230 may include a display region including a plurality of pixels. For example, an active region may be referred to as an active region displaying visual information.

According to an embodiment, the display 230 may include a first flat portion 231, a second flat portion 232, and a bending portion 233 disposed between the first flat portion 231 and the second flat portion 232. The electronic device 101 may further include a cover display 235 distinguished from the display 230. The cover display 235 may be referred to as a sub-display.

According to an embodiment, the first flat portion 231 may be supported by the first housing part 210. The second flat portion 232 may be supported by the second housing part 220. The first flat portion 231 and the second flat portion 232 may be substantially flat independently of a state of the electronic device 101. The bending portion 233 may be configured to be bent based on rotation of the first housing part 210 and the second housing part 220. For example, in the unfolded state in which the first housing part 210 and the second housing part 220 are unfolded, the bending portion 233 may be substantially flat. In the folded state or an intermediate state in which the first housing part 210 and the second housing part 220 are folded, the bending portion 233 may be at least partially bent. The display 230 may be a flexible display including the bendable bending portion 233.

According to an embodiment, one or more cameras 240 may be configured to obtain an image based on receiving light from an external subject of the electronic device 101. For example, the one or more cameras 240 may include first cameras 241, a second camera 242, and/or a third camera 243. For example, the first cameras 241 may be disposed in the first housing part 210. For example, when the electronic device 101 is viewed from above, the first housing part 210 may include at least one opening 241a overlapping the first cameras 241. The first cameras 241 may obtain an image based on receiving light from the outside of the electronic device 101 through the at least one opening 241a.

According to an embodiment, the second camera 242 may be disposed in the second housing part 220. When the electronic device 101 is viewed from above, the second housing part 220 may include at least one opening 242a overlapping the second camera 242. The second camera 242 may obtain an image based on receiving light from the outside of the electronic device 101 through the at least one opening 242a.

According to an embodiment, the third camera 243 may be disposed in the first housing part 210. For example, when the display 230 is viewed from above, the first flat portion 231 of the display 230 may include at least one opening overlapping the third camera 243. The third camera 243 may obtain an image based on receiving light from the outside of the display 230 through the at least one opening.

According to an embodiment, the second camera 242 and the third camera 243 may be disposed below the display 230 or the cover display 235 (e.g., in a -z direction). For example, the second camera 242 and/or the third camera 243 may include an under display camera (UDC) and/or a punch hole camera.

According to an embodiment, the first housing part 210 and the second housing part 220 may be rotatably coupled. For example, the second housing part 220 may be rotatably coupled to the first housing part 210 through the hinge assembly 250.

According to an embodiment, the hinge assembly 250 may rotatably connect the first housing part 210 and the second housing part 220. The hinge assembly 250 may be disposed between the first housing part 210 and the second housing part 220 of the electronic device 101 such that the electronic device 101 may be folded. The hinge assembly 250 may enable the electronic device 101 to change from the unfolded state to the folded state. The hinge assembly 250 may enable the electronic device 101 to change from the folded state to the unfolded state. For example, the hinge assembly 250 may maintain the electronic device 101 in the intermediate state between the unfolded state and the folded state.

The hinge assembly 250 may be configured to provide the folded state in which the first flat portion 231 faces the second flat portion 232 and the unfolded state in which the first flat portion 231 and the second flat portion 232 face substantially the same direction by rotatably coupling the first housing part 210 and the second housing part 220. For example, the hinge assembly 250 may rotatably connect the first housing part 210 and the second housing part 220. For example, the hinge assembly 250 may be at least partially disposed between the first housing part 210 and the second housing part 220. For example, the hinge assembly 250 may support the bending portion 233 (e.g., a foldable portion) of the display 230. For example, the hinge assembly 250 may be configured to deform the bending portion 233 by rotatably coupling the first housing part 210 and the second housing part 220. For example, the hinge assembly 250 may at least partially overlap the bending portion 233 when the display 230 is viewed from above (e.g., when viewed in the -z direction).

According to an embodiment, the unfolded state may be referred to as a state in which a first direction to which the first flat portion 231 faces and a second direction to which the second flat portion 232 faces are substantially the same. The folded state may be referred to as a state in which the first direction is substantially opposite to the second direction. When the electronic device 101 is in the folded state, the first housing part 210 and the second housing part 220 may be stacked or overlapped.

According to an embodiment, when the electronic device 101 is in the folded state and the intermediate state, the first direction and the second direction may be different from each other. For example, when the electronic device 101 is in the folded state, the first direction and the second direction may be opposite to each other. For example, when the electronic device 101 is in the intermediate state, the first direction may form an angle (e.g., an angle greater than 0 degrees and less than 180 degrees) with respect to the second direction.

For example, the electronic device 101 may include at least one conductive portion 214a and/or 224a and at least one non-conductive portion 214b and/or 224b included in the first side surface 213 and/or the second side surface 223. For example, the at least one conductive portion 214a and/or 224a may be separated from another conductive portion in the first side surface 213 and/or the second side surface 223 by contacting the at least one non-conductive portion 214b and/or 224b. In an embodiment, the at least one conductive portion 214a and/or 224a may operate as an antenna radiator to be used for communication with an external electronic device.

Referring to FIG. 2C, the hinge assembly 250 may include a hinge cover 251, a first hinge plate 252, a second hinge plate 253, and a plurality of hinge modules 254. The hinge cover 251 may at least partially cover components of the hinge assembly 250 and form an outer surface of the hinge assembly 250. When the electronic device 101 is in the folded state, the hinge cover 251 may be at least partially exposed to the outside of the electronic device 101 through a space between the first housing part 210 and the second housing part 220. When the electronic device 101 is in the unfolded state, the hinge cover 251 may not be exposed to the outside of the electronic device 101 by being covered by the first housing part 210 and the second housing part 220.

According to an embodiment, the first hinge plate 252 and the second hinge plate 253 may rotatably connect the first housing part 210 and the second housing part 220 by being operatively coupled to the first housing part 210 and the second housing part 220, respectively. For example, the first hinge plate 252 may be operatively coupled to a first support member 215 of the first housing part 210, and the second hinge plate 253 may be operatively coupled to a second support member 227 of the second housing part 220. As the first hinge plate 252 and the second hinge plate 253 are operatively coupled to the first support member 215 and the second support member 227, respectively, the first housing part 210 and the second housing part 220 may be rotatable according to rotation of the first hinge plate 252 and the second hinge plate 253.

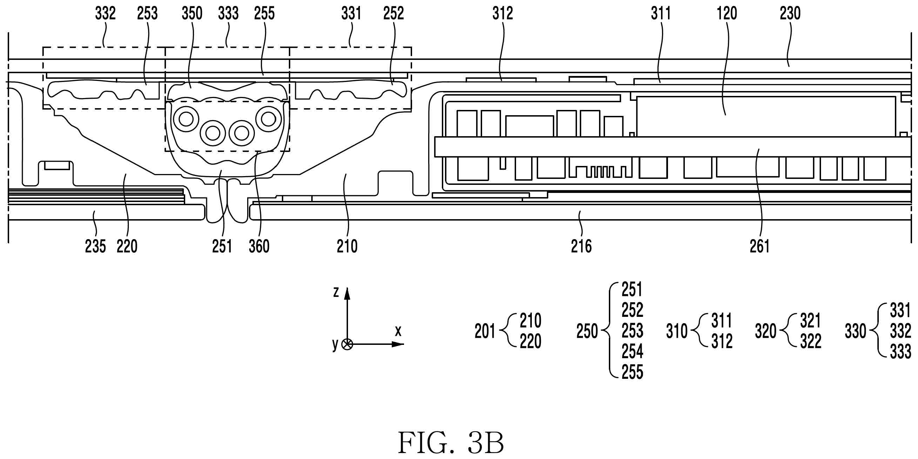

According to an embodiment, the plurality of hinge modules 254 may rotate the first hinge plate 252 and the second hinge plate 253. For example, the plurality of hinge modules 254 may include gears (e.g., 360 of FIG. 3B) that are engaged with each other and rotatable. The first hinge plate 252 and the second hinge plate 253 may be rotated based on the rotation operation of the gears of the plurality of hinge modules 254.

According to an embodiment, the first housing part 210 may include the first support member 215 and a rear cover 216. The first support member 215 may be disposed inside the first housing part 210 and may support at least one component disposed in the first housing part 210. The rear cover 216 may at least partially form the second surface 212 of the first housing part 210. For example, the second housing part 220 may include the second support member 227. The second support member 227 may be disposed inside the second housing part 220 and may support at least one component disposed in the second housing part 220. For example, the cover display 235 may be disposed under the second support member 227 (e.g., in the -z direction).

The electronic device 101 according to an embodiment may include a plurality of electronic components for implementing various functions in addition to the one or more cameras 240 described above. For example, the electronic device 101 may include a first printed circuit board 261, a second printed circuit board 262, a flexible printed circuit board 263, and/or a battery 189. The above-described electronic components are merely exemplary and are not limited thereto.

For example, the first printed circuit board 261 and the second printed circuit board 262 may each provide an electrical connection of components in the electronic device 101. For example, the first printed circuit board 261 may be disposed in the first housing part 210, and the second printed circuit board 262 may be disposed in the second housing part 220. The first printed circuit board 261 may provide an electrical connection between electronic components disposed in the first housing part 210. The second printed circuit board 262 may provide an electrical connection between electronic components disposed in the second housing part 220. The flexible printed circuit board 263 may electrically connect the first printed circuit board 261 and the second printed circuit board 262. For example, the flexible printed circuit board 263 may extend from the first printed circuit board 261 across the hinge assembly 250 to the second printed circuit board 262. For example, the flexible printed circuit board 263 may at least partially overlap the hinge assembly 250.

According to an embodiment, the battery 189, which is a device for supplying power to at least one component of the electronic device 101, may include, for example, a non-rechargeable primary battery and/or a rechargeable secondary battery.

According to an embodiment, the electronic device 101 may include a plurality of antennas ANT1, ANT2, ANT3, or ANT4 to be used for communication with an external electronic device. For example, the electronic device 101 may include a main antenna ANT1, a sub-antenna ANT2, an ultra-wide band (UWB) antenna ANT3, and/or an antenna ANT4 for short-range wireless communication. However, it is not limited thereto.

The electronic device 101 according to an embodiment may include a heat dissipation member 255 (e.g., a first heat dissipation member) configured to dissipate heat caused from electronic components (or heat sources) (e.g., the processor 120, the communication module 190, and/or the power management module 188 of FIG. 1). For example, the heat dissipation member 255 may be a heat dissipation sheet including graphite and/or graphene having high thermal conductivity. The heat dissipation member 255 may diffuse heat inside the electronic device 101 and reduce an increase in temperature of the electronic device 101. For example, the heat dissipation member 255 may diffuse heat caused from electronic components in the first housing part 210 to the second housing part 220.

Hereinafter, one or more components to be described later with reference to drawings may be implemented together with the components of the electronic device 101 described with reference to FIGS. 2A, 2B, and 2C. The same reference numerals are assigned to the same components as the above-described components, and overlapping descriptions may be omitted.

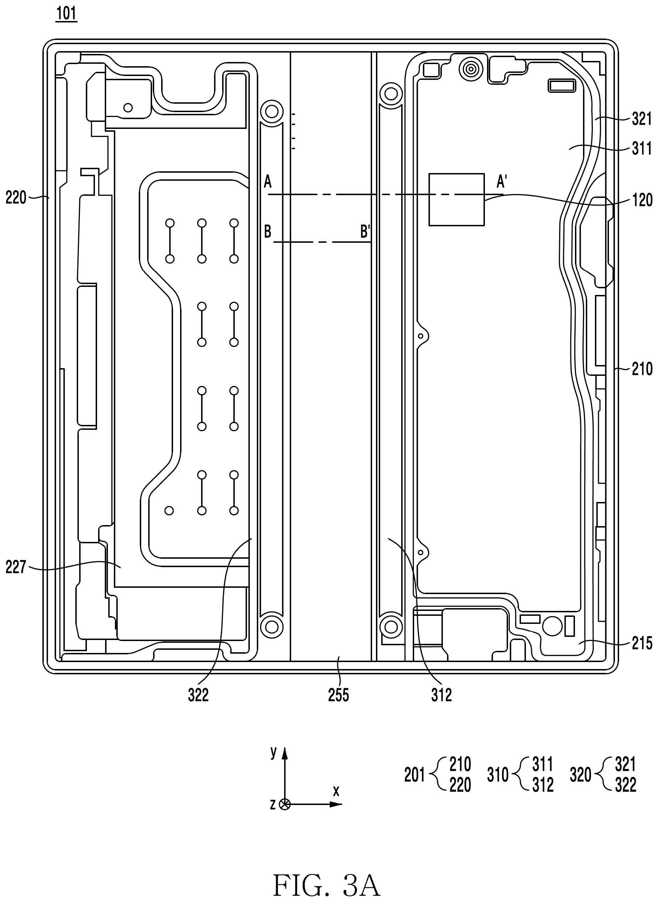

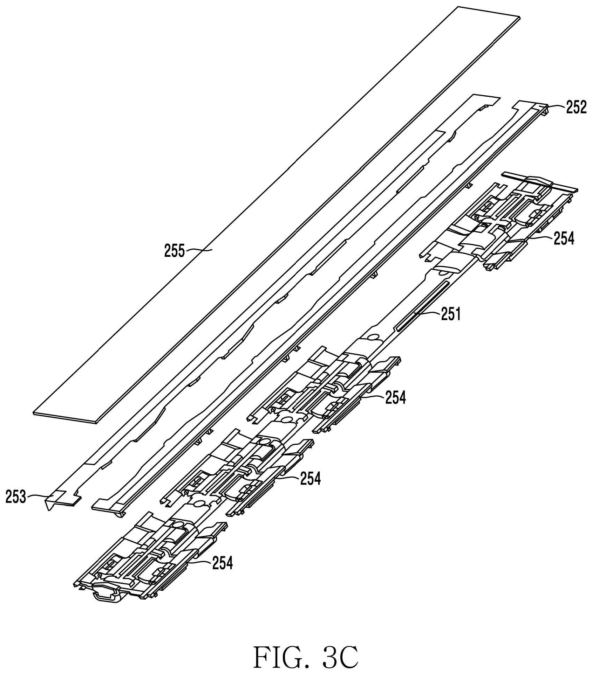

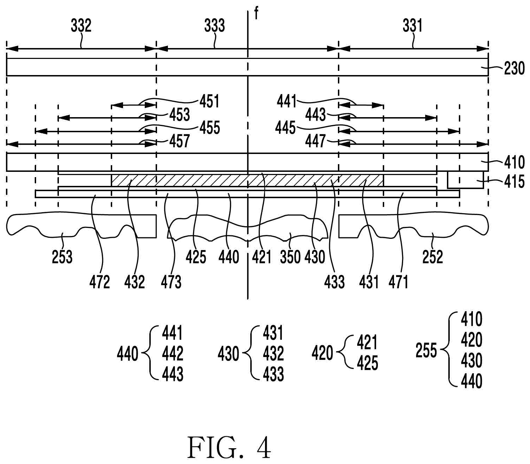

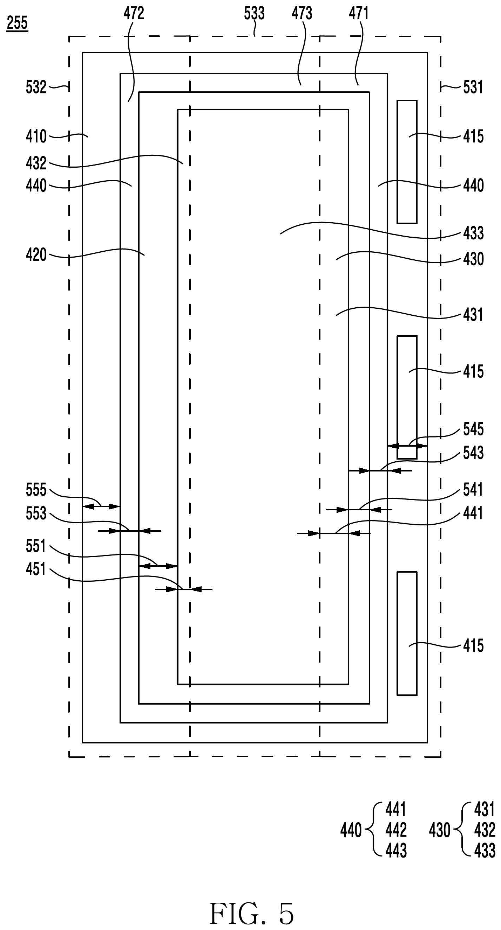

FIG. 3A illustrates an interior of an electronic device according to an embodiment. FIG. 3B is a cross-sectional view in which the electronic device of FIG. 3A is cut along line A-A'. FIG. 3C is an exploded view of an electronic device according to an embodiment. FIG. 4 is a cross-sectional view in which the electronic device of FIG. 3A is cut along line B-B'. FIG. 5 illustrates a structure of a heat dissipation sheet according to an embodiment.

FIG. 3A is a front view of an electronic device 101 from which a display (e.g., the display 230 of FIG. 2A) is removed.

An electronic device (e.g., the electronic device 101 of FIGS. 1 and 2A to 2C) according to an embodiment may include a foldable housing 201 that defines an exterior of the electronic device 101. The foldable housing 201 may be configured to be folded or unfolded. For example, the foldable housing 201 may include a first housing part 210 and a second housing part 220. The first housing part 210 and the second housing part 220 may be rotatably coupled to each other through a hinge assembly 250. For example, the hinge assembly 250 may include a first hinge plate 252 coupled to the first housing part 210 and a second hinge plate 253 coupled to the second housing part 220. The second hinge plate 253 may be rotatable relative to the first hinge plate 252. When an external force causing rotation is applied to the first housing part 210 and/or the second housing part 220, the first hinge plate 252 and/or the second hinge plate 253 may be rotated. As the first housing part 210 and/or the second housing part 220 are rotated by the rotation of the first hinge plate 252 and/or the second hinge plate 253, a state of the electronic device 101 may be changed.

According to an embodiment, the first housing part 210 may include a first support member 215, and the second housing part 220 may include a second support member 227. The first support member 215 may support electronic components disposed in the first housing part 210. The second support member 227 may support electronic components disposed in the second housing part 220.

According to an embodiment, the electronic device 101 may include a display 230. As described above, the display 230 may be a flexible display. The display 230 may include a first flat portion (e.g., the first flat portion 231 of FIG. 2A), a second flat portion (e.g., the second flat portion 232 of FIG. 2A), and a bending portion (e.g., the bending portion 233 of FIG. 2A). A first flat portion 231 may be supported by the first support member 215 below the first flat portion 231 (e.g., in a -z direction). A second flat portion 232 may be supported by the second support member 227 below the second flat portion 232. The bending portion 233 may be configured to be bent based on rotation of the first housing part 210 and the second housing part 220.

A glass window disposed on the front surface of the display 230 may be omitted such that the bending portion 233 may be bent, or an ultra thin glass (UTG) having a very thin thickness may be disposed on the front surface of the display 230. Since the glass window is omitted or the UTG is disposed on the front surface of the display 230, the display 230 may be easily damaged by an impact. For example, since the first support member 215 and the second support member 227 disposed under the display 230 are rigid, damage to the display 230 may be caused by contact between the display 230 and the support members 215 and 227.

The electronic device 101 according to an embodiment may include components for absorbing an impact applied to the display 230 under the display 230 (e.g., in the -z direction).

The electronic device 101 according to an embodiment may include a waterproof tape 320. For example, the waterproof tape 320 may include a first waterproof tape 321 and a second waterproof tape 322. The first waterproof tape 321 disposed on the first support member 215 of the first housing part 210 and the second waterproof tape 322 disposed on the second support member 227 of the second housing part 220 may be formed from a material having elasticity. The first waterproof tape 321 and the second waterproof tape 322 may be disposed between the foldable housing 201 and the display 230.

The electronic device 101 according to an embodiment may include a heat dissipation member 310 configured to dissipate heat caused from electronic components. For example, the heat dissipation member 310 may be a heat dissipation sheet including graphite and/or graphene having high thermal conductivity. The heat dissipation member 310 may diffuse heat inside the electronic device 101 and reduce an increase in temperature of the electronic device 101.

In an embodiment, the heat dissipation member 310 may include a heat dissipation member 311 (e.g., a second heat dissipation member) covering a processor 120. For example, the heat dissipation member 311 may completely overlap the processor 120 such that the entire area of the processor 120 is covered by the heat dissipation member when viewed in a direction perpendicular to the display surface of the flexible display in the unfolded state (i.e. the z-direction in FIG. 3B). For example, the heat dissipation member 311 may be disposed in the first housing part 210. For example, the heat dissipation member 311 may be physically spaced apart from a heat dissipation member 255 (e.g., at least by the first waterproof tape 321).

In an embodiment, the heat dissipation member 310 may include a heat dissipation member 312 (e.g., a third heat dissipation member) positioned between the heat dissipation member 311 and the heat dissipation member 255. For example, the heat dissipation member 312 may be disposed in the first housing part 210. For example, the heat dissipation member 312 may be physically spaced apart from the heat dissipation member 311 (at least by the first waterproof tape 321). For example, the heat dissipation member 312 may be physically spaced apart from the heat dissipation member 255.

Referring to FIG. 3B, the electronic device 101 according to an embodiment may include a printed circuit board 261. The printed circuit board 261 may be disposed on the first support member 215. The printed circuit board 261 may include a plurality of conductive layers and a plurality of non-conductive layers alternately laminated with the plurality of conductive layers. The printed circuit board 261 may provide an electrical connection between various electronic components disposed on the printed circuit board 261 and/or outside the printed circuit board 261 using wirings and conductive vias formed on the conductive layer.

According to an embodiment, heat caused from the electronic components (e.g., the processor 120) disposed on the printed circuit board 261 may be diffused by the heat dissipation member 255, 311, or 312. For example, the heat caused when the electronic components disposed on the printed circuit board 261 operate may be conducted to the heat dissipation member 310 through the printed circuit board 261, the first support member 215 of the first housing part 210, diffused through the heat dissipation member 310, and emitted to the outside of the electronic device 101. The heat dissipation member 310 may reduce damage to electronic components by reducing a temperature of the electronic device 101, and may reduce performance degradation due to overheating. For example, heat-causing electronic components may include the processor 120 (e.g., an application processor (AP) and/or a power management circuit 340), but are not limited thereto.

In an embodiment, the heat dissipation member 255, 311, or 312 may be formed from a material having high thermal conductivity so as to conduct and dissipate heat. In an embodiment, the heat dissipation member 255, 311, or 312 may include a thermal diffusion member (e.g., 430 of FIG. 4) including graphite and/or graphene. The thermal diffusion member 430 including the graphite and/or the graphene may be suitable as a material forming the heat dissipation member 255 since it has flexibility, high durability, and high thermal conductivity. Since the graphite and/or the graphene have a single crystal, they have low bursting strength and low yield strength. The graphite and/or the graphene may be easily broken as the graphite and/or the graphene have low bursting strength and low yield strength. In order to prevent and/or reduce diffusion of dust from the graphite and/or the graphene inside the electronic device 101, the thermal diffusion member 430 may be disposed inside the electronic device 101 in a form of an encapsulation structure covered by an encapsulation film. For example, the encapsulation structure may include an upper film and a lower film covering the thermal diffusion member 430. For example, the encapsulation film may completely overlap the thermal diffusion member 430 such that the entire area of the thermal diffusion member 430 is covered by the encapsulation film when viewed in a direction perpendicular to the display surface of the flexible display in the unfolded state (i.e. the z-direction in FIG. 3B). The thermal diffusion member 430 may be disposed between the upper film and the lower film, and a periphery of the upper film and a periphery of the lower film may be attached to each other. In an embodiment, the thermal diffusion member (e.g., 430 of FIG. 4) may include carbon. For example, the thermal diffusion member (e.g., 430 of FIG. 4) may include a carbon fiber or a carbon film. For example, the thermal diffusion member (e.g., 430 of FIG. 4) may be formed by mixing the carbon fiber and a resin (e.g., epoxy).

Referring to FIG. 3B, the heat dissipation member 255, 311, or 312 may be disposed under the flexible display 230 (e.g., in a -z-axis direction or a direction perpendicular to the plane formed by the display 230 in the unfolded state). In an embodiment, the heat dissipation member 255 may be disposed above the hinge assembly 250 (e.g., in a +z-axis direction).

In an embodiment, the flexible display 230 may include a bendable portion 330, which is unfolded (or substantially flattened) when the electronic device 101 is unfolded, and/or is bent when the electronic device 101 is folded. In an embodiment, a portion 330 of the flexible display 230 may be referred to as the bendable portion 330. The bendable portion 330 may correspond to the bending portion 233 in FIG. 2A.

In an embodiment, referring to FIGS. 3B and 3C, the hinge assembly 250 may include a first hinge plate 252 and a second hinge plate 253. For example, the hinge assembly 250 may also include a plurality of hinge modules 254, and a center plate 350. For example, the plurality of hinge modules 254 may include gears 360 that are engaged with each other and rotatable. The first hinge plate 252 and the second hinge plate 253 may be rotated, for example based on a rotation operation of the gears of the plurality of hinge modules 254. In an embodiment, the first hinge plate 252 and the second hinge plate 253 may be described as a first wing plate and a second wing plate, respectively. The center plate 350 may have a bar shape extending parallel to a folding axis f of the electronic device 101. In this respect, the center plate 350 may be described as a center bar 350.

In an embodiment, the center plate 350 may be disposed under the heat dissipation member 255 (e.g., in the -z direction). For example, the center plate 350 may be disposed under a third portion 333 (e.g., in the -z direction) of the bendable portion 330. In a state in which the electronic device 101 is unfolded, the center plate 350 may be positioned between the first hinge plate 252 and the second hinge plate 253.

In an embodiment, the first hinge plate 252 and the second hinge plate 253 may be disposed under the heat dissipation member 255 (e.g., in the -z direction). For example, the first hinge plate 252 may be disposed under a first portion 331 (e.g., in the -z direction) of the bendable portion 330. For example, the second hinge plate 253 may be disposed under a second portion 332 (e.g., in the -z direction) of the bendable portion 330.

In an embodiment, when the electronic device 101 is folded, the first hinge plate 252 and the second hinge plate 253 may respectively rotate in a direction in which the electronic device 101 is folded. For example, when the electronic device 101 is folded, the first hinge plate 252 and the second hinge plate 253 may respectively rotate toward each other. In an embodiment, when the electronic device 101 is folded, the first hinge plate 252 and the second hinge plate 253 may bend the flexible display 230 (or the bendable portion 330 of the flexible display 230) into a specified shape.

In an embodiment, the heat dissipation member 255 may be positioned (or interposed) between the bendable portion 330 of the flexible display 230 and the hinge assembly 250. In an embodiment, the heat dissipation member 255 may include the first portion 331 of the bendable portion 330 of the flexible display 230 and/or a first portion (e.g., 531 of FIG. 5) overlapping the first hinge plate 252 of the hinge assembly 250. In an embodiment, the heat dissipation member 255 may include the second portion 332 of the bendable portion 330 of the flexible display 230 and/or a second portion (e.g., 532 of FIG. 5) overlapping the second hinge plate 253 of the hinge assembly 250. In an embodiment, the heat dissipation member 255 may include the third portion 333 of the bendable portion 330 of the flexible display 230 and/or a third portion (e.g., 533 of FIG. 5) overlapping the center plate 350 of the hinge assembly 250.

Referring to FIG. 4, the heat dissipation member 255 may include a support member 410, an adhesive member 420, the thermal diffusion member 430, and/or a cushion member 440. According to an embodiment, the heat dissipation member 255 may further include an additional member. For example, the heat dissipation member 255 may include an additional cushion member between the flexible display 230 and the support member 410. According to an embodiment, the additional cushion member may be configured to absorb the impact of the flexible display 230 by being disposed under the flexible display 230. The additional cushion member may include a material such as a sponge having elasticity to alleviate the impact applied to the flexible display 230. In an embodiment, the additional cushion member may include Polytetrafluoroethylene (PTFE). In an embodiment, a thickness of the additional cushion member may be thinner than a thickness of the cushion member 440. For example, the thickness of the additional cushion member may be approximately 24 micrometers.

In an embodiment, the cushion member 440 may include a first side surface close to the first housing part 210 (or overlapping the first hinge plate 252) and a second side surface close to the second housing part 220 (or overlapping the second hinge plate 253).

In an embodiment, the heat dissipation member 255 may be attached fixedly to the first hinge plate 252 through an adhesive member 415 (e.g., a double-sided tape). In an embodiment, the heat dissipation member 255 may be at least partially fixed to the first hinge plate 252. In an embodiment, the support member 410 may be attached fixedly to the first hinge plate 252 through the adhesive member 415.

In an embodiment, the support member 410 may be disposed under the flexible display 230. In an embodiment, the support member 410 may be positioned between the thermal diffusion member 430 and the flexible display 230. In an embodiment, the support member 410 may cover a first surface of the thermal diffusion member 430 (or a surface facing the flexible display 230). For example, the support member 410 may completely overlap the first surface of the thermal diffusion member 430 such that the entire area of the first surface of the thermal diffusion member 430 is covered by the support member 410 when viewed in a direction perpendicular to the display surface of the flexible display in the unfolded state (i.e. the z-direction in FIG. 3B). In an embodiment, the support member 410 may include carbon fiber reinforced plastic (CFRP). In an embodiment, a thickness of the support member 410 may be approximately 50 micrometers.

In an embodiment, the adhesive member 420 may attach the plurality of layers 410, 430, and 440 in the heat dissipation member 255 to each other. In an embodiment, the adhesive member 420 may include an adhesive material. For example, the adhesive member 420 may include a pressure sensitive adhesive (PSA). In an embodiment, the adhesive member 420 may include a first adhesive member 421 covering the first surface of the thermal diffusion member 430 (or the surface facing the flexible display 230), and a second adhesive member 425 covering a second surface opposite to the first surface of the thermal diffusion member 430 (or a surface facing the hinge assembly 250). In an embodiment, each of the first adhesive member 421 and the second adhesive member 425 may be approximately 10 micrometers. For example, a thickness (in a direction perpendicular to the first or second surface of the thermal diffusion member 430) of each of the first adhesive member 421 and the second adhesive member 425 may be approximately 10 micrometers.

In an embodiment, the first adhesive member 421 may be disposed between the thermal diffusion member 430 and the support member 410, and cover the first surface of the thermal diffusion member 430. For example, the first adhesive member 421 may completely overlap the first surface of the thermal diffusion member 430 such that the entire area of the first surface of the thermal diffusion member 430 is covered by the first adhesive member 421 when viewed in a direction perpendicular to the display surface of the flexible display in the unfolded state (i.e. the z-direction in FIG. 3B). In an embodiment, the second adhesive member 425 may be disposed between the thermal diffusion member 430 and the cushion member 440, and cover the second surface of the thermal diffusion member 430. For example, the second adhesive member 425 may completely overlap the second surface of the thermal diffusion member 430 such that the entire area of the second surface of the thermal diffusion member 430 is covered by the second adhesive member 425 when viewed in a direction perpendicular to the display surface of the flexible display in the unfolded state (i.e. the z-direction in FIG. 3B).

In an embodiment, in terms of the thermal diffusion member 430 being covered by the adhesive member 420, the adhesive member 420 may be referred to as the encapsulation structure. For example, the first adhesive member 421 may be referred to as an upper encapsulation structure, and the second adhesive member 425 may be referred to as a lower encapsulation structure.

For example, the thermal diffusion member 430 may be fully covered by the second adhesive member 425. When the second adhesive member 425 is attached to the first adhesive member 421, the thermal diffusion member 430 may be covered by the first adhesive member 421 and the second adhesive member 425. The thermal diffusion member 430 being covered by the first adhesive member 421 and the second adhesive member 425 may be referred to as not being exposed to the outside of the first adhesive member 421 and the second adhesive member 425 as the thermal diffusion member 430 is disposed between the first adhesive member 421 and the second adhesive member 425.

In an embodiment, the thermal diffusion member 430 may include a thermally conductive material (e.g., graphite or graphene). In an embodiment, the thermal diffusion member 430 may include the thermally conductive material (e.g., graphite or graphene) in a broken state. Accordingly, dust of the thermally conductive material may be caused. When the dust of the thermally conductive material is diffused into the electronic device 101, damage or malfunction of electronic components in the electronic device 101 may be caused. According to an embodiment, the thermal diffusion member 430 may be covered by the first adhesive member 421 and the second adhesive member 425 by being disposed on the second adhesive member 425 and covered by the first adhesive member 421. The thermally conductive material (e.g., graphite or graphene) may not be leaked outside the encapsulation structure in a space covered by the first adhesive member 421 and the second adhesive member 425. The in-plane (e.g., in a direction (e.g., an x-axis direction) perpendicular to the folding axis f) thermal conductivity of the thermally conductive material may be equal to or more than 200 W/m·K.

In an embodiment, a thickness (e.g. in a direction perpendicular to the first or second surface of the thermal diffusion member 430) of the thermal diffusion member 430 may be approximately from 17 micrometers to 32 micrometers.

In an embodiment, the cushion member 440 may be disposed above the hinge assembly 250. In an embodiment, the cushion member 440 may be positioned between the thermal diffusion member 430 and the hinge assembly 250. According to an embodiment, the cushion member 440 may be configured to absorb an impact of the hinge assembly 250 by being disposed above the hinge assembly 250. The cushion member 440 may include a material such as a sponge having elasticity. In an embodiment, the cushion member 440 may include Polytetrafluoroethylene.

In an embodiment, the cushion member 440 may cover the second surface of the thermal diffusion member 430 (or the surface facing the hinge assembly 250). For example, the cushion member 440 may completely overlap the second surface of the thermal diffusion member 430 such that the entire area of the second surface of the thermal diffusion member 430 is covered by the cushion member 440 when viewed in a direction perpendicular to the display surface of the flexible display in the unfolded state (i.e. the z-direction in FIG. 3B). In an embodiment, a thickness (e.g. in a direction perpendicular to the second surface of the thermal diffusion member 430) of the cushion member 440 may be thicker than a thickness of an additional cushion member. For example, the thickness of the cushion member 440 may be approximately 28 micrometers.

In an embodiment, the support member 410, the adhesive member 420, the thermal diffusion member 430, and/or the cushion member 440 may have different widths. In an embodiment, the support member 410, the adhesive member 420, the thermal diffusion member 430, and/or the cushion member 440 may have different areas.

For example, referring to FIG. 4, a width 441 of the portion of the thermal diffusion member 430 that overlaps the first hinge plate 252 (or the first portion 331 of the flexible display 230) (or a width in a direction perpendicular to the folding axis f and parallel to the first or second surface of the thermal diffusion member 430), a width 443 of the portion of the adhesive member 420 that overlaps the first hinge plate 252, a width 445 of the portion of the cushion member 440 that overlaps the first hinge plate 252, and/or a width 447 of the portion of the support member 410 that overlaps the first hinge plate 252 may be different from each other.

For example, a width 451 of a portion of the thermal diffusion member 430 that overlaps the second hinge plate 253 (or the second portion 332 of the flexible display 230) (or a width in a direction perpendicular to the folding axis f and parallel to the first or second surface of the thermal diffusion member 430), a width 453 of a portion of the adhesive member 420 that overlaps the second hinge plate 253, a width 455 of a portion of the cushion member 440 that overlaps the second hinge plate 253, and/or a width 457 of a portion of the support member 410 that overlaps the second hinge plate 253 may be different from each other.

In an embodiment, among the support member 410, the adhesive member 420, the thermal diffusion member 430, and/or the cushion member 440, the thermal diffusion member 430 may be asymmetrical (or may be disposed asymmetrically) in a direction perpendicular to the folding axis f. For example, the width 441 of the portion of the thermal diffusion member 430 that overlaps the first hinge plate 252 may be greater than the width 451 of the portion of the thermal diffusion member 430 that overlaps the second hinge plate 253. For example, the area (or proportion) of the first hinge plate 251 (or the first portion 331 of the flexible display 230) overlapped by the thermal diffusion member 430 may be greater than the area (or proportion) of the second hinge plate 253 (or the second portion 332 of the flexible display 230) overlapped by the thermal diffusion member 430.

In an embodiment, among the support member 410, the adhesive member 420, the thermal diffusion member 430, and/or the cushion member 440, the support member 410, the adhesive member 420, and the cushion member 440 may be symmetrical (or disposed symmetrically) in a direction perpendicular to the folding axis f (and parallel to the first or second surface of the thermal diffusion member 430). For example, the width 447 of the portion of the support member 410 that overlaps the first hinge plate 252 may correspond to (e.g. be equal to, or substantially equal to) the width 457 of the portion of the support member 410 that overlaps the second hinge plate 253. For example, the width 443 of the portion of the adhesive member 420 that overlaps the first hinge plate 252 may correspond to the width 453 of the portion of the adhesive member 420 that overlaps the second hinge plate 253. For example, the width 445 of the portion of the cushion member 440 that overlaps the first hinge plate 252 may correspond to the width 455 of the portion of the cushion member 440 that overlaps the second hinge plate 253. For example, the area (or proportion) of the first hinge plate 251 (or the first portion 331 of the flexible display 230) overlapped by the cushion member 440 may be equal (or substantially equal) to the area (or proportion) of the second hinge plate 253 (or the second portion 332 of the flexible display 230) overlapped by the cushion member 440.

In an embodiment, a thickness of the heat dissipation member 255 including the support member 410, the adhesive member 420, the thermal diffusion member 430, the cushion member 440, and the additional cushion member may be equal to or less than 160 micrometers (e.g., approximately from 139 micrometers to 154 micrometers).

In an embodiment, referring to FIG. 5, the heat dissipation member 255 may include a first heat dissipation member portion 531, a second heat dissipation member portion 532, and a third heat dissipation member portion 533.

In an embodiment, the first heat dissipation member portion 531 may correspond to (or overlap) the first portion 331 of the flexible display 230 and/or the first hinge plate 252 (during a state (e.g., a state of the electronic device 101 in FIG. 2A) in which the electronic device 101 is unfolded). In an embodiment, the first heat dissipation member portion 531 may be attached fixedly to the first hinge plate 252.

In an embodiment, the second heat dissipation member portion 532 may correspond to (or overlap) the second portion 332 of the flexible display 230 and/or the second hinge plate 253 (during a state (e.g., a state of the electronic device 101 in FIG. 2A) in which the electronic device 101 is unfolded). In an embodiment, the second heat dissipation member portion 532 may not be fixed to the first hinge plate 252. In an embodiment, the second heat dissipation member portion 532 may not be fixed to the second hinge plate 253. For example, the second heat dissipation member portion 532 may be moved relative to the second hinge plate 253 when the first housing part 210 is rotated relative to the second housing part 220. For example, the second heat dissipation member portion 532 may be slid relative to the second hinge plate 253 as the foldable housing 201 is folded or unfolded.

In an embodiment, the third heat dissipation member portion 533 may correspond to (or overlap) the third portion 333 of the flexible display 230 and/or the center plate 350 (during a state (e.g., a state of the electronic device 101 in FIG. 2A) in which the electronic device 101 is unfolded). In an embodiment, the third heat dissipation member portion 533 may not be fixed to the center plate 350. For example, the third heat dissipation member portion 533 may be moved relative to the center plate 350 when the first housing part 210 is rotated relative to the second housing part 220.

In an embodiment, the thermal diffusion member 430 in the first heat dissipation member portion 531 and the second heat dissipation member portion 532 may be different from each other in a shape. For example, a portion of the thermal diffusion member 430 in the first heat dissipation member portion 531 may have a different shape to a portion of the thermal diffusion member 430 in the second heat dissipation member portion 532. Hereinafter, the thermal diffusion member 430 in the first heat dissipation member portion 531 may be referred to as a first thermal diffusion member portion 431. The thermal diffusion member 430 in the second heat dissipation member portion 532 may be referred to as a second thermal diffusion member portion 432. The thermal diffusion member 430 in the third heat dissipation member portion 533 may be referred to as a third thermal diffusion member portion 433.

For example, the first width 441 in the direction perpendicular to the folding axis of the hinge assembly 250 (and parallel to the first or second surface of the thermal diffusion member 430) of the first thermal diffusion member portion 431 may be greater than the second width 451 in the direction of the second thermal diffusion member portion 432. For example, the area of the first thermal diffusion member portion 431 may be greater than the area of the second thermal diffusion member portion 432. For example, a shape of the first thermal diffusion member portion 431 may be different from a shape of the second thermal diffusion member portion 432. For example, the shapes of the first thermal diffusion member portion 431 and the second thermal diffusion member portion 432 being different may include that the widths of the first thermal diffusion member portion 431 and the second thermal diffusion member portion 432 are different.

In an embodiment, the cushion member 440 in the first heat dissipation member portion 531 and the second heat dissipation member portion 532 may be different from each other in a shape. For example, a portion of the cushion member 440 in the first heat dissipation member portion 531 may have a different shape to a portion of the thermal diffusion member 430 in the second heat dissipation member portion 532. Hereinafter, the cushion member 440 in the first heat dissipation member portion 531 may be referred to as a first cushion member portion 471. The cushion member 440 in the second heat dissipation member portion 532 may be referred to as a second cushion member portion 472. The cushion member 440 in the third heat dissipation member portion 533 may be referred to as a third cushion member portion 473.

For example, an offset (e.g., a sum of an offset 541 between the end of the first thermal diffusion member portion 431 and the end of the adhesive member 420 and an offset 543 between the end of the adhesive member 420 and the end of the first cushion member portion 471) between the first cushion member portion 471 and the first thermal diffusion member portion 431 may be smaller than an offset (e.g., a sum of an offset 551 between the end of the second thermal diffusion member portion 432 and the end of the adhesive member 420 and an offset 553 between the end of the adhesive member 420 and the end of the second cushion member portion 472) between the second cushion member portion 472 and the second thermal diffusion member portion 432. For example, the offset between the first cushion member portion 471 and the first thermal diffusion member portion 431 (e.g., the sum of the offset 541 and the offset 543) may be approximately 1 millimeter. For example, the offset between the second cushion member portion 472 and the second thermal diffusion member portion 432 (e.g., the sum of the offset 551 and the offset 553) may be approximately from 1.3 millimeters to 1.5 millimeters.

In an embodiment, the adhesive member 420 (or the first adhesive member 421 and/or the second adhesive member 425) in the first heat dissipation member portion 531 and the second heat dissipation member portion 532 may be different from each other in a shape. For example, a portion of the adhesive member 420 in the first heat dissipation member portion 531 may have a different shape to a portion of the adhesive member 420 in the second heat dissipation member portion 532. Hereinafter, the adhesive member 420 in the first heat dissipation member portion 531 may be referred to as a first adhesive member portion. The adhesive member 420 in the second heat dissipation member portion 532 may be referred to as a second adhesive member portion.

For example, the offset 541 between the first adhesive member portion and the first thermal diffusion member portion 431 may be smaller than the offset 551 between the second adhesive member portion and the second thermal diffusion member portion 432. In an embodiment, the offset 551 may be equal to twice the offset 541 or may be less than twice the offset 541. For example, the offset 551 may be approximately from 0.8 millimeters to 1 millimeter. For example, the offset 541 may be approximately 0.5 millimeters.

In an embodiment, the support member 410 in the first heat dissipation member portion 531 may be referred to as a first support member portion. The support member 410 in the second heat dissipation member portion 532 may be referred to as a second support member portion.

For example, an offset 545 between the first support member portion and the first cushion member portion 471 may correspond to (e.g. be equal to, or substantially equal to) an offset 555 between the second support member portion and the second cushion member portion 472. For example, the offset 545 or 555 may be approximately 1 millimeter. According to an embodiment, an offset between the first support member portion and the first cushion member portion 471 at a position where the adhesive member 415 is disposed among the first support member portion may be greater than an offset between the first support member portion and the first cushion member portion 471 at a position where the adhesive member 415 is not disposed among the first support member portion. According to an embodiment, one or more adhesive members 415 may be arranged to be adhered to the first hinge plate 252 within the first support member portion along the folding axis.

As described above, the thermal diffusion member 430 may be asymmetrical with respect to the folding axis f. For example, the first width 441 of the portion of the thermal diffusion member 430 that overlaps the first hinge plate 252 may be greater than the second width 451 of the portion of the thermal diffusion member 430 that overlaps the second hinge plate 253. Accordingly, for example, the offset 541 between the first adhesive member portion and the first thermal diffusion member portion 431 may be smaller than the offset 551 between the second adhesive member portion and the second thermal diffusion member portion 432. As the offset 541 is smaller than the offset 551, the thermal diffusion member 430 may prevent or reduce heat from diffusing into the electronic device 101 by passing through the second heat dissipation member portion 532. As the first housing part 210 rotates relative to the second housing part 220, even when the electronic device 101 transitions between the folded state and the flat state, peeling and/or damage to the encapsulation structure by the adhesive member 420 may be reduced or prevented.

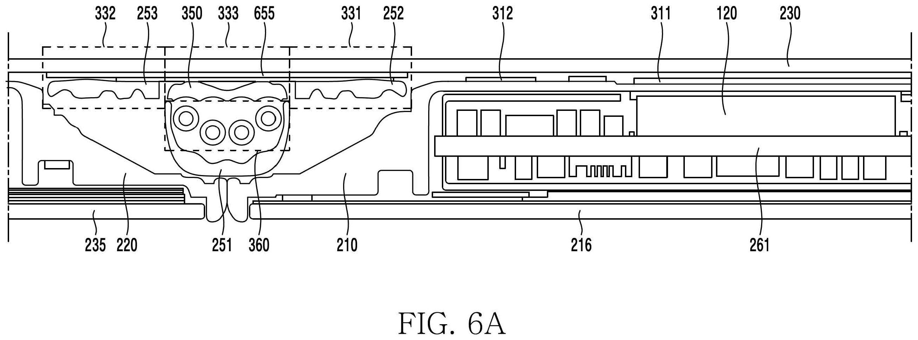

As described above, the heat dissipation member 255 covering both the first hinge plate 252 and the second hinge plate 253 has been described. Hereinafter, a heat dissipation member asymmetrically covering the first hinge plate 252 and the second hinge plate 253 will be described with reference to FIGS. 6A to 11.

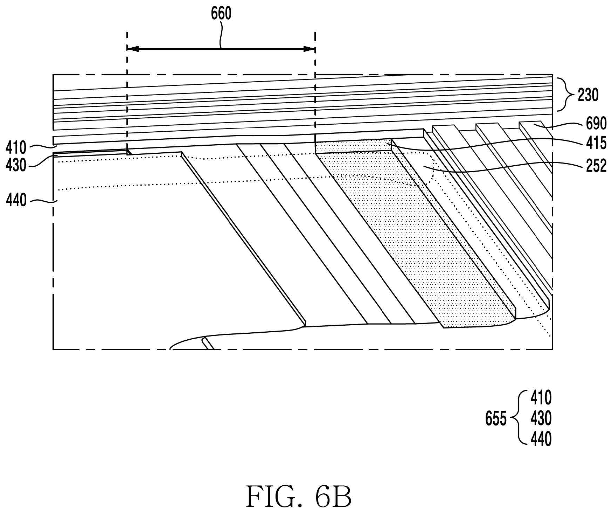

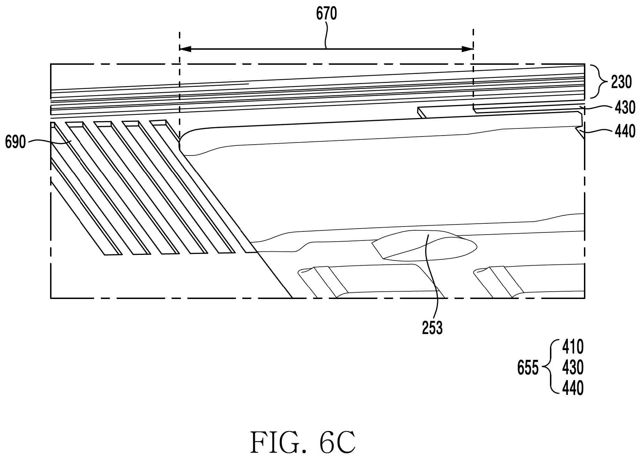

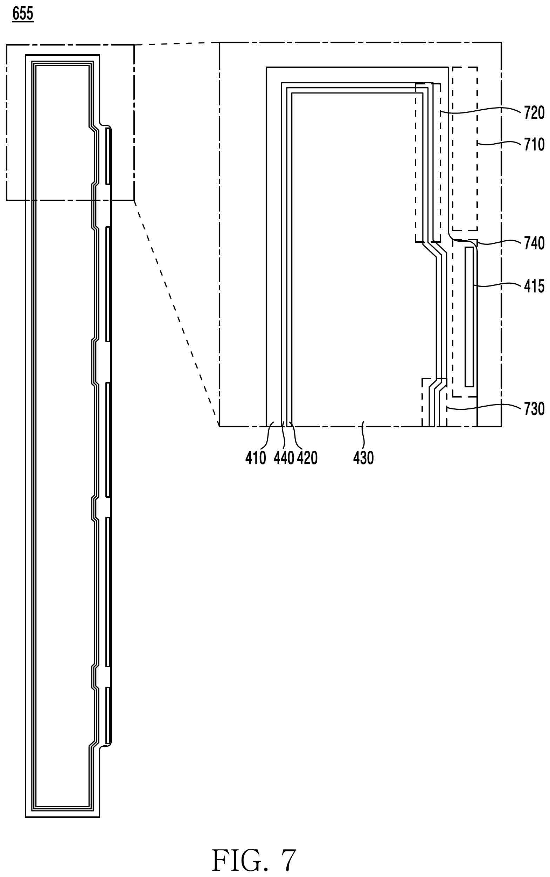

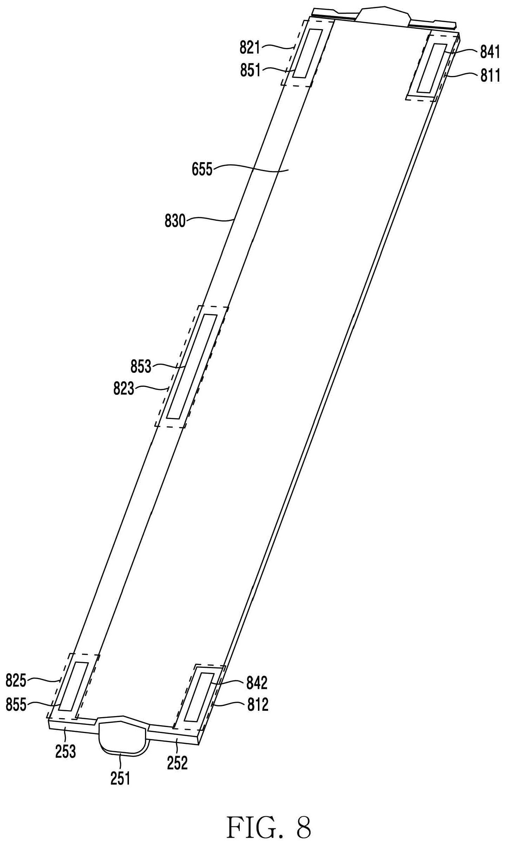

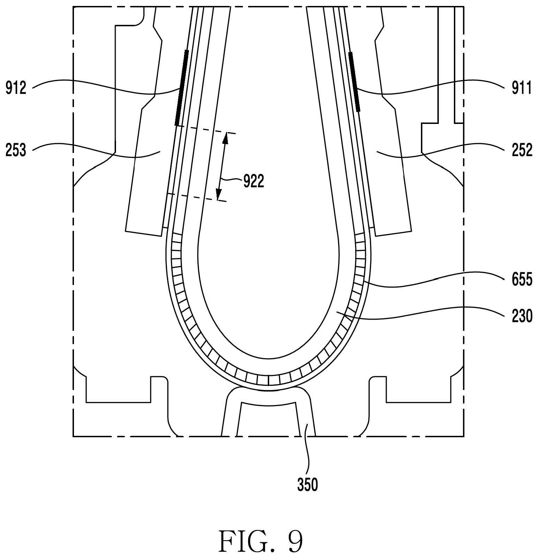

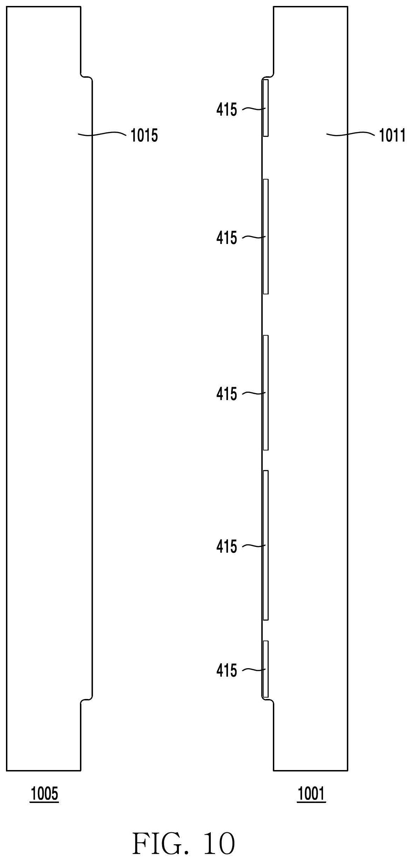

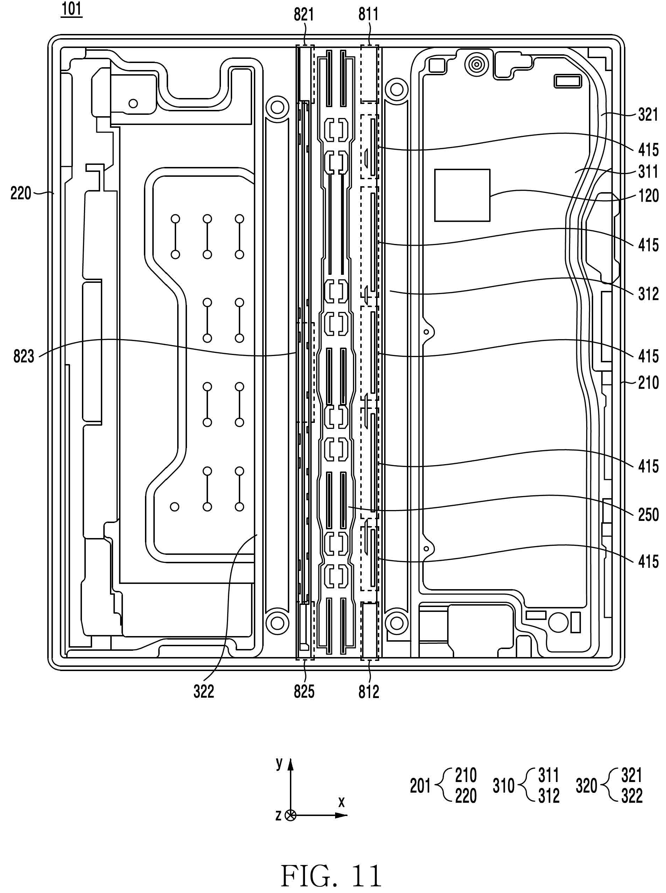

FIG. 6A is a cross-sectional view of an electronic device according to an embodiment. FIGS. 6B and 6C are perspective views of an electronic device according to an embodiment. FIG. 7 illustrates a structure of a heat dissipation sheet according to an embodiment. FIG. 8 illustrates a heat dissipation sheet attached to a hinge assembly, according to an embodiment. FIG. 9 illustrates a state in which a hinge assembly, to which a heat dissipation sheet is attached, is folded according to an embodiment. FIG. 10 illustrates a heat dissipation sheet according to an embodiment. FIG. 11 illustrates an interior of an electronic device according to an embodiment.

Referring to FIG. 6A, a heat dissipation member 655 may be positioned (or interposed) between a bendable portion 330 of a flexible display 230 and a hinge assembly 250. In an embodiment, the heat dissipation member 655 may include a first portion 331 of the bendable portion 330 of the flexible display 230 and/or a first portion overlapping a first hinge plate 252 of the hinge assembly 250. In an embodiment, the heat dissipation member 655 may include a second portion 332 of the bendable portion 330 of the flexible display 230 and/or a second portion overlapping a second hinge plate 253 of the hinge assembly 250. In an embodiment, the heat dissipation member 655 may include a third portion 333 of the bendable portion 330 of the flexible display 230 and/or a third portion overlapping a center plate 350 of the hinge assembly 250.

In an embodiment, referring to FIG. 6A, the heat dissipation member 655 may be attached fixedly to the first hinge plate 252 through an adhesive member 415 (e.g., a double-sided tape).

In an embodiment, referring to FIGS. 6A and 6C, the heat dissipation member 655 may be disposed under the flexible display 230 (and/or under a plate 690). In an embodiment, the plate 690 may be disposed under the flexible display 230. The plate 690 may be attached to at least a portion of a back surface of the flexible display 230. The plate 690 may be formed to have predetermined rigidity in order to support the flexible display 230 and protect the flexible display 230. As a non-limiting example, the plate 690 may be formed from metal (e.g., aluminum and/or titanium). For example, the plate 690 may be formed from plastic (e.g., carbon fiber reinforced plastic (CFRP)). According to an embodiment, the plate 690 may be described as being included in the flexible display 230.

In an embodiment, the heat dissipation member 655 may include a support member 410, a thermal diffusion member 430, and/or a cushion member 440. In an embodiment, the support member 410, the thermal diffusion member 430, and/or the cushion member 440 may correspond to the support member 410, the thermal diffusion member 430, and/or the cushion member 440 described with reference to FIGS. 4 and 5. In an embodiment, the heat dissipation member 655 may include an adhesive member (e.g., the adhesive member 420 described with reference to FIGS. 4 and 5).

In an embodiment, referring to FIG. 6B, the thermal diffusion member 430 may be recessed (or indented) from the adhesive member 415 by a specified interval 660 such that the heat dissipation member 655 is attached to the first hinge plate 252.

In an embodiment, referring to FIG. 6C, the heat dissipation member 655 (or the support member 410, the thermal diffusion member 430, and/or the cushion member 440) may be recessed (or indented) from the second hinge plate 253 (and/or the first hinge plate 252) by a specified interval 670 such that the adhesive member (e.g., 841, 842, 851, 853, and 855 of FIG. 8) attaching the plate 690 and the second hinge plate 253 (and/or the first hinge plate 252) to each other is disposed.

For example, referring to FIG. 7, the heat dissipation member 655 may have a shape of not covering the second hinge plate 253 (and/or the first hinge plate 252) by a space 710 where the adhesive member (e.g., 841, 842, 851, 853, and 855 of FIG. 8) attaching the plate 690 and the second hinge plate 253 (and/or the first hinge plate 252) to each other is disposed. For example, the heat dissipation member 655 may be recessed (or indented) from the first hinge plate 252 by the space 710 where the adhesive member (e.g., 841, 842, 851, 853, and 855 of FIG. 8) is disposed. For example, the heat dissipation member 655 may be recessed (or indented) from the edge of the first hinge plate 252 to provide a space 710 where an adhesive member (e.g., 841, 842, 851, 853, and 855 of FIG. 8) may be disposed. As the heat dissipation member 655 is recessed (or indented) from the first hinge plate 252 by the space 710, side surfaces of the support member 410, the adhesive member 420, the thermal diffusion member 430, and/or the cushion member 440 of the heat dissipation member 655 may be positioned at a position 720 recessed by the space 710.

In an embodiment, referring to FIG. 7, among the support member 410, the adhesive member 420, the thermal diffusion member 430, and the cushion member 440, the adhesive member 420, the thermal diffusion member 430, and/or the cushion member 440 may be offset by a space 740 from the support member 410 (or the adhesive member 415). For example, the adhesive member 420, the thermal diffusion member 430, and/or the cushion member 440 may be offset by a space 740 from the edge of the support member 410 (or the adhesive member 415). For example, the adhesive member 415 may be arranged only on the side surface of the support member 410 close to the first hinge plate 252 among the first hinge plate 252 and the second hinge plate 253. For example, the surface of the support member 410 on which the cushion member 440 is disposed may have a first side closer to the first hinge plate 252 than to the second hinge plate 253, and a second side closer to the second hinge plate 253 than to the first hinge plate 252, and the adhesive member 415 may be arranged only on the first side. Accordingly, the heat dissipation member 655 may be attached fixedly to the first hinge plate 252 and may be moved relative to the second hinge plate 253.

According to an embodiment, according to a structure in the second hinge plate 253 (and/or the first hinge plate 252), the side surfaces (or edges) of the adhesive member 420, the thermal diffusion member 430, and/or the cushion member 440 among the support member 410, the adhesive member 420, the thermal diffusion member 430, and the cushion member 440 may be positioned at a position 730 recessed from the support member 410 (e.g. recessed from the edge of the support member 410). In an embodiment, as the thermal diffusion member 430, the adhesive member 420, and/or the cushion member 440 are positioned at the position 730 recessed from the support member 410 in a direction perpendicular to a folding axis f (e.g. recessed from the edge of the support member 410 in a direction perpendicular to a folding axis f and parallel to the first or second surface of the thermal diffusion member 430), the thermal diffusion member 430 may be recessed with respect to a side surface of the support member 410 and/or a side surface of the cushion member 440.

In an embodiment, as the support member 410, the adhesive member 420, the thermal diffusion member 430, and the cushion member 440 have different offsets, the support member 410, the adhesive member 420, the thermal diffusion member 430, and/or the cushion member 440 may have different widths. In an embodiment, the support member 410, the adhesive member 420, the thermal diffusion member 430, and/or the cushion member 440 may have different areas. In an embodiment, the support member 410 may further protrude in a direction perpendicular to a longitudinal direction (or the folding axis f) (and parallel to the first or second surface of the thermal diffusion member 430) of the heat dissipation member 655 than the support member 410, the adhesive member 420, and/or the cushion member 440. In an embodiment, the thermal diffusion member 430 may protrude less in the direction perpendicular to the longitudinal direction (or the folding axis f) of the heat dissipation member 655 than the support member 410, the adhesive member 420, and/or the cushion member 440.

For example, the thermal diffusion member 430 may be offset with respect to the first hinge plate 252 and/or the second hinge plate 253 to be covered by the first hinge plate 252 and/or the second hinge plate 253. For example, the adhesive member 420 may be greater (e.g. have greater size or area) than the thermal diffusion member 430 to cover the thermal diffusion member 430. For example, the thermal diffusion member 430 may be covered by the adhesive member 420.

In an embodiment, referring to FIG. 8, the first hinge plate 252 may be attached to the flexible display 230 (and/or the plate 690) through the adhesive members 841 and 842. In an embodiment, the second hinge plate 253 may be attached to the flexible display 230 (and/or the plate 690) through the second adhesive members 851, 853, and 855. The number (e.g., two) of the first adhesive members 841 and 842 may be less than the number (e.g., three) of the second adhesive members 851, 853, and 855. For example, the first hinge plate 252 may be attached to the flexible display 230 (and/or the plate 690) by fewer adhesive members than the second hinge plate 253.

In an embodiment, the heat dissipation member 655 may not cover at least a portion 830 of a periphery region of the second hinge plate 253 while a foldable housing 201 is fully unfolded. In an embodiment, the heat dissipation member 655 may expose the at least a portion 830 of the periphery region of the second hinge plate 253 while the foldable housing 201 is fully unfolded.

In an embodiment, the heat dissipation member 655 may be disposed above the first hinge plate 252 and the second hinge plate 253 asymmetrically with respect to the folding axis f by a width of the at least a portion 830. For example, a width (e.g., 441 of FIG. 4) overlapping the first hinge plate 252 of the heat dissipation member 655 may be greater than a width (e.g., 451 of FIG. 4) overlapping the second hinge plate 253 of the heat dissipation member 655. For example, the width 441 (or an offset between the heat dissipation member 655 and the first hinge plate 252) overlapping the first hinge plate 252 in a direction perpendicular to the folding axis f at a portion of the heat dissipation member 655 where the first adhesive member 841 or 842 is absent may be smaller than the width 451 (or an offset between the heat dissipation member 655 and the second hinge plate 253) overlapping the second hinge plate 253 in a direction perpendicular to the folding axis f at a portion of the heat dissipation member 655 where the second adhesive member 851, 853, or 855 is absent. For example, the width 441 may indicate the greatest width in a direction of the thermal diffusion member 430 (e.g. a direction perpendicular to the folding axis f and parallel to the first or second surface of the thermal diffusion member 430) in the portion (or the first heat dissipation member portion 531 of FIG. 5) of the heat dissipation member 655 where the first adhesive member 841 or 842 is absent. For example, the second width 451 may indicate the greatest width in a direction of the thermal diffusion member 430 in the portion (or the second heat dissipation member portion 532 of FIG. 5) of the heat dissipation member 655 where the second adhesive member 851, 853, or 855 is absent.

In an embodiment, the heat dissipation member 655 may not overlap at least one display fixed region 841, 842, 851, 853, and/or 855 when viewed in a direction substantially perpendicular to the flexible display 230 (e.g. a direction substantially perpendicular to the display surface of the flexible display 230).

In an embodiment, the heat dissipation member 655 may have an extent (or area) smaller than an extent (or area) of the hinge assembly 250 (or an extent of the first hinge plate 252, the second hinge plate 253, and the center plate 350).

In an embodiment, the first heat dissipation member portion 531 and the second heat dissipation member portion 532 may have substantially different shapes when viewed in a direction substantially perpendicular to the flexible display 230 (e.g. a direction substantially perpendicular to the display surface of the flexible display 230). For example, referring to FIG. 8, the second heat dissipation member portion 532 may have a rectangular shape by being recessed by the at least a portion 830 of the periphery region of the second hinge plate 253. For example, referring to FIG. 8, the first heat dissipation member portion 531 may have a shape other than a rectangular shape by being recessed by two display fixed regions 811 and 812.

In an embodiment, the first hinge plate 252 and the second hinge plate 253 may include at least one display fixed region 811, 812, 821, 823, and/or 825 adhered to a portion of the flexible display 230 (or the plate 690). The first hinge plate 252 and the second hinge plate 253 may be attached to the flexible display 230 (or the plate 690) through the adhesive member 841, 842, 851, 853, or 855 in the fixed region 811, 812, 821, 823, or 825.

Referring to FIG. 9, the heat dissipation member 655 may overlap the first hinge plate 252 and the second hinge plate 253 to be asymmetrical. For example, the heat dissipation member 655 may extend in a direction perpendicular to the folding axis f to be close to a portion 911 where the first hinge plate 252 is attached to the flexible display 230, while the heat dissipation member 655 may extend in a direction perpendicular to the folding axis f to be spaced apart from a portion 912 where the second hinge plate 253 is attached the flexible display 230. Accordingly, the heat dissipation member 655 may not overlap the second hinge plate 253 by an interval 922 corresponding to the at least a portion 830 of the periphery region of the second hinge plate 253.

Referring to an example 1001 of FIG. 10, the heat dissipation member 655 may include a plurality of adhesive members 415 (e.g., a double-sided tape) on a first surface 1011 facing the hinge assembly 250 (e.g., the first hinge plate 252). On the other hand, referring to an example 1005 of FIG. 10, the heat dissipation member 655 may not include a plurality of adhesive member 415 (e.g., a double-sided tape) on a second surface 1015 opposite to the first surface 1011 facing the flexible display 230. In an embodiment, referring to the examples 1001 and 1005, the heat dissipation member 655 may protrude longer in a direction facing towards the first hinge plate 252 than in a direction facing towards the second hinge plate 253.

Referring to FIG. 11, the heat dissipation member 655 protruding longer in the direction facing the first hinge plate 252 may be disposed not to cover the at least one display fixed regions 811, 812, 821, 823, and 825 on the hinge assembly 250.

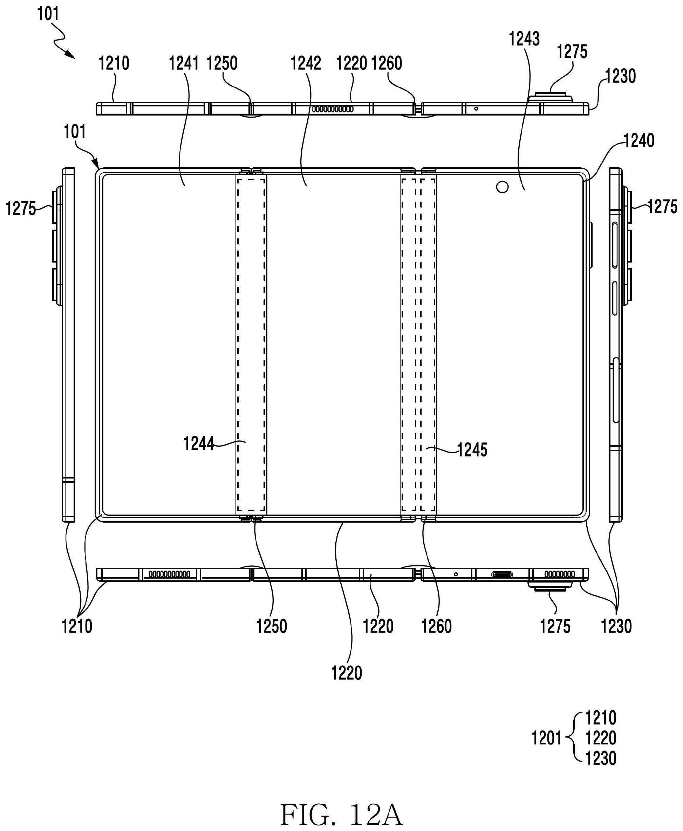

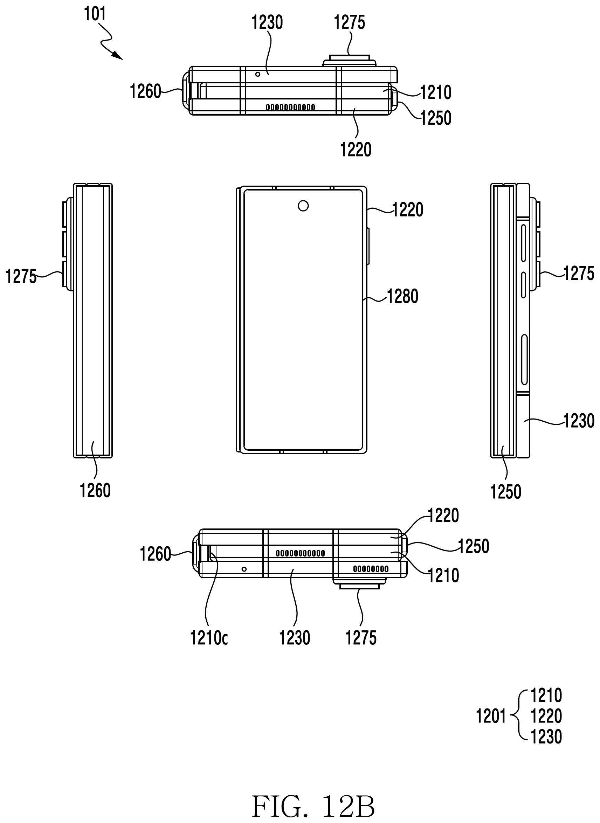

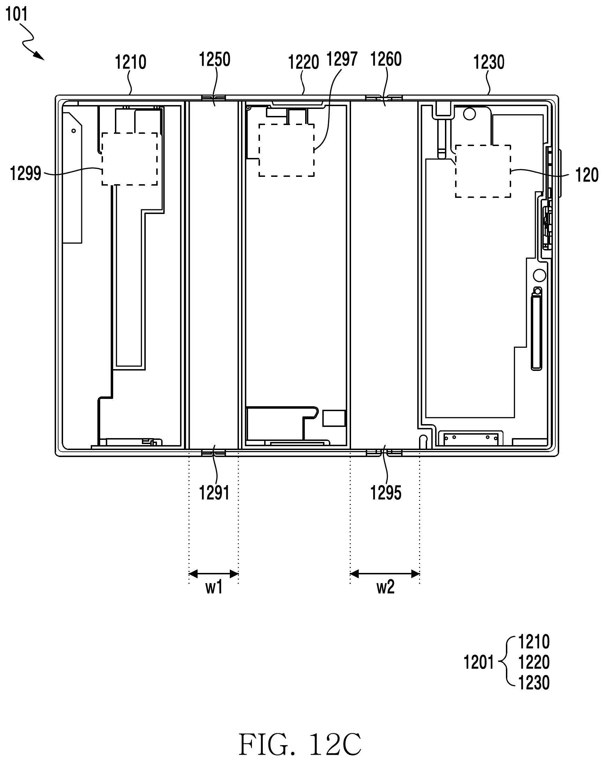

FIG. 12A illustrates an exemplary electronic device in a first state. FIG. 12B illustrates an exemplary electronic device in a second state. FIG. 12C is a plan view of an exemplary electronic device in a first state from which a flexible display is removed.

Referring to FIGS. 12A and 12B, an electronic device 101 may include a housing 1201, a flexible display 1240, a first hinge assembly 1250, and a second hinge assembly 1260. The housing 1201 may include a first housing part 1210, a second housing part 1220, and a third housing part 1230. The housing 1201 includes a plurality of housing parts 1210, 1220, and 1230 and may be referred to as a multi-foldable housing in terms of being foldable several times. The electronic device 101 may be referred to as a multi-foldable electronic device in terms of including the multi-foldable housing 1201 and/or the flexible display 1240. But an embodiment is not limited thereto.

The first housing part 1210 may be rotatably coupled to the second housing part 1220 by the first hinge assembly 1250. The second housing part 1220 and the first housing part 1210 may be rotated relative to the first hinge assembly 1250. While the first housing part 1210 is rotated relative to the first hinge assembly 1250, the second housing part 1220 may be rotated relative to the first hinge assembly 1250. For example, when the second housing part 1220 and the first housing part 1210 are rotated relative to the first hinge assembly 1250, an angular displacement of the second housing part 1220 may be substantially the same as an angular displacement of the first housing part 1210.

The third housing part 1230 may be rotatably coupled to the second housing part 1220 by the second hinge assembly 1260. The second housing part 1220 and the third housing part 1230 may be rotated relative to the second hinge assembly 1260. While the second housing part 1220 is rotated relative to the second hinge assembly 1260, the third housing part 1230 may be rotated relative to the second hinge assembly 1260. For example, when the second housing part 1220 and the third housing part 1230 rotate relative to the second hinge assembly 1260, the angular displacement (or an angular change) of the second housing part 1220 may be substantially the same as an angular displacement of the third housing part 1230.

The first hinge assembly 1250 and the second hinge assembly 1260 may change a state of the electronic device. The first hinge assembly 1250 and the second hinge assembly 1260 may provide (or enable) a first state of the electronic device 101 (or a first state of the housing 1201). The first state of the electronic device 101 (or the first state of the housing 1201) may be described as an unfolded state of the electronic device 101 (or the housing 1201). In the first state, a front surface of the first housing part 1210, a front surface of the second housing part 1220, and a front surface of the third housing part 1230 may define a front surface of the electronic device 101. In the first state, the front surface of the first housing part 1210, the front surface of the second housing part 1220, and the front surface of the third housing part 1230 may face substantially the same direction. In the first state, the electronic device 101 may provide a user with a large display region of the flexible display 1240.

The first hinge assembly 1250 and the second hinge assembly 1260 may provide a second state of the electronic device 101 (or a second state of the housing 1201). The second state of the electronic device 101 (or the second state of the housing 1201) may be described as a multi-folded state of the electronic device 101 (or the housing 1201). In the second state, the front surface of the first housing part 1210 and the front surface of the second housing part 1220 may face opposite directions, and the front surface of the second housing part 1220 and the front surface of the third housing part 1230 may face opposite directions. In the second state, the front surface of the first housing part 1210 and the front surface of the third housing part 1230 may face the same direction. For example, in the second state, the front surface of the second housing part 1220 may face the front surface of the first housing part 1210, and the front surface of the third housing part 1230 may face a rear surface of the first housing part 1210. In the second state, the electronic device 101 may be folded to improve portability.

The first hinge assembly 1250 and the second hinge assembly 1260 may provide a third state of the electronic device 101. The third state of the electronic device 101 may be described as a state in which the electronic device 101 is partially folded and partially unfolded (or a single folded state or a semi-folded state). For example, in the third state, the front surface of the second housing part 1220 and the front surface of the third housing part 1230 may face the same direction, and the front surface of the first housing part 1210 and the front surface of the second housing part 1220 may face opposite directions. For example, in the third state, the first housing part 1210 and the second housing part 1220 may be folded, and the second housing part 1220 and the third housing part 1230 may be unfolded.

The flexible display 1240 may at least partially define an exterior of the electronic device 101. The flexible display 1240 may be partially disposed in the housing 1201. The flexible display 1240 may define the front surface of the electronic device 101. The flexible display 1240 may include a first flat portion 1241, a second flat portion 1242, a third flat portion 1243, a first foldable portion 1244, and a second foldable portion 1245. The first flat portion 1241 of the flexible display 1240 may be disposed on the front surface of the first housing part 1210. The second flat portion 1242 of the flexible display 1240 may be disposed on the front surface of the second housing part 1220. The third flat portion 1243 of the flexible display 1240 may be disposed on the front surface of the third housing part 1230. The first foldable portion 1244 of the flexible display 1240 may be disposed between the first flat portion 1241 and the second flat portion 1242 of the flexible display 1240. For example, the first foldable portion 1244 of the flexible display 1240 may be disposed on the first hinge assembly 1250 connecting the first housing part 1210 and the second housing part 1220. The second foldable portion 1245 of the flexible display 1240 may be disposed between the second flat portion 1242 and the third flat portion 1243 of the flexible display 1240. For example, the second foldable portion 1245 of the flexible display 1240 may be disposed on the second hinge assembly 1260 connecting the second housing part 1220 and the third housing part 1230.

In the first state, the entire display region of the flexible display 1240 may be visible from a front surface of the housing 1201. For example, the first flat portion 1241, the second flat portion 1242, the third flat portion 1243, the first foldable portion 1244, and the second foldable portion 1245 of the flexible display 1240 may be visually exposed. The electronic device 101 may provide the user with a large display region including the first flat portion 1241, the second flat portion 1242, the third flat portion 1243, the first foldable portion 1244, and the second foldable portion 1245. In the second state, a display region of the flexible display 1240 may not be visible. For example, the first flat portion 1241, the second flat portion 1242, the third flat portion 1243, the first foldable portion 1244, and the second foldable portion 1245 of the flexible display 1240 may not be visually exposed. In the third state, a display region of the flexible display 1240 may be partially visible from the front surface of the third housing part 1230. For example, the third flat portion 1243 may be visually exposed, and the first flat portion 1241 and the second flat portion 1242 may not be visually exposed.

As a non-limiting example, when the flexible display 1240 is used to display a screen in the first state of the electronic device 101, all portions 1241, 1242, 1243, 1244, and 1245 of the flexible display 1240 may be activated. As a non-limiting example, in the second state, all portions 1241, 1242, 1243, 1244, and 1245 of the flexible display 1240 may be deactivated. As a non-limiting example, when the flexible display 1240 is used to display a screen in the third state of the electronic device 101, the third flat portion 1243 may be activated and other portions 1241, 1242, 1244, and 1245 of the flexible display 1240 may be deactivated.

The first hinge assembly 1250 and the second hinge assembly 1260 may face substantially the same direction as the first flat portion 1241 of the flexible display 1240, the second flat portion 1242 of the flexible display 1240, and the third flat portion 1243 of the flexible display 1240. In the first state, the first foldable portion 1244 and the second foldable portion 1245 may be disposed on substantially the same horizontal plane as the first flat portion 1241, the second flat portion 1242, and the third flat portion 1243.

The first hinge assembly 1250 and the second hinge assembly 1260 may provide the second state of the electronic device 101. In the second state, the second flat portion 1242 of the flexible display 1240 may face the first flat portion 1241 of the flexible display 1240, and the third flat portion 1243 of the flexible display 1240 may face the rear surface of the first housing part 1210. In the second state, the first foldable portion 1244 of the flexible display 1240 may be folded such that the first flat portion 1241 of the flexible display 1240 and the second flat portion 1242 of the flexible display 1240 face different directions. In the second state, the second foldable portion 1245 of the flexible display 1240 may be folded such that the second flat portion 1242 of the flexible display 1240 and the third flat portion 1243 of the flexible display 1240 face different directions.

In the second state, the first housing part 1210 may be disposed between the second housing part 1220 and the third housing part 1230. In the second state, the second foldable portion 1245 of the flexible display 1240 disposed on the second hinge assembly 1260 may partially face a side surface 1210c of the first housing part 1210. For example, in order to provide visual information to the user in the second state, a sub-display 1280 may be additionally disposed on the rear surface of the second housing part 1220. For example, in the second state, the sub-display 1280 may be configured to provide visual information to the user instead of the flexible display 1240. For example, a camera 1275 may be partially protruded or exposed through a rear surface of the third housing part 1230 to obtain an image regardless of a change in the state of the electronic device 101. For example, in the first state, the flexible display 1240 may be configured to display visual information associated with the image through the flexible display 1240 using the image obtained through the camera 1275. For example, in the second state, the sub-display 1280 may be configured to display visual information associated with the image through the sub-display 1280 using the image obtained through the camera 1275. However, an embodiment supported by the present disclosure is not limited thereto.

Referring to FIG. 12C, the electronic device 101 may include the first hinge assembly 1250 and the second hinge assembly 1260. A first width w1 of the first hinge assembly 1250 may be narrower than a second width w2 of the second hinge assembly 1260. A difference between the first width w1 of the first hinge assembly 1250 and the second width w2 of the second hinge assembly 1260 may be equal to or greater than a thickness of the first housing part 1210. For example, the second hinge assembly 1260 may have the second width w2 greater than the first width w1 such that the first housing part 1210 is disposed between the second housing part 1220 and the third housing part 1230 according to the second state. The first hinge assembly 1250 may be referred to as a narrow hinge assembly in terms of having a narrower width than the second hinge assembly 1260. The second hinge assembly 1260 may be referred to as a wide hinge assembly in terms of having a wider width than the first hinge assembly 1250.

The electronic device 101 may include a plurality of printed circuit boards. Various hardware components (or heat sources) may be mounted on each of the plurality of printed circuit boards. For example, a hardware component (e.g., a display controller 1299) may be disposed on a printed circuit board in the first housing part 1210. For example, a hardware component (e.g., a direct charging circuit 1297) may be disposed on a printed circuit board in the second housing part 1220. For example, a hardware component (e.g., a processor 120) may be disposed on a printed circuit board in the third housing part 1230.

The electronic device 101 according to an embodiment may include at least one heat dissipation member 1291 and/or 1295 configured to dissipate heat caused from electronic components (or heat sources) (e.g., the processor 120, the communication module 190 of FIG. 1, the power management module 188 of FIG. 1, the direct charging circuit 1297, and/or the display controller 1299). For example, the at least one heat dissipation member 1291 and/or 1295 may be a heat dissipation sheet including graphite and/or graphene, which have high thermal conductivity. The at least one heat dissipation member 1291 and/or 1295 may diffuse heat inside the electronic device 101 and reduce an increase in a temperature of the electronic device 101. For example, the heat dissipation member 1291 may diffuse heat caused from electronic components in the first housing part 1210 to the second housing part 1220. For example, the heat dissipation member 1291 may diffuse heat caused from electronic components in the second housing part 1220 to the first housing part 1210. For example, the heat dissipation member 1295 may diffuse heat caused from electronic components in the second housing part 1220 to the third housing part 1230. For example, the heat dissipation member 1295 may diffuse heat caused from electronic components in the third housing part 1230 to the second housing part 1220.

The technical problems to be achieved in this document are not limited to those described above, and other technical problems not mentioned herein will be clearly understood by those having ordinary knowledge in the art to which the present disclosure belongs, from the following description.

An electronic device 101 as described above may include a housing 201. The housing 201 may include a first housing part 210 and a second housing part 220. The electronic device 101 may include a flexible display 230 including a bendable portion 330 configured to bend when the first housing part 210 is rotated relative to the second housing part 220. The electronic device 101 may include a hinge assembly 250 disposed under the flexible display 230 and rotatably connecting the first housing part 210 and the second housing part 220 such that the first housing part 210 is rotated relative to the second housing part 220. The hinge assembly 250 may include a first hinge plate 252, and a second hinge plate 253, with the first hinge plate 252, configured to bend the bendable portion 330 into a specified shape. The electronic device 101 may include a heat dissipation member 255 positioned between the bendable portion 330 and the hinge assembly 250, and including a thermal diffusion member 430. The heat dissipation member 255 may include a first heat dissipation member portion 531 overlapping the first hinge plate 252 and attached fixedly to the first hinge plate 252, and a second heat dissipation member portion 532 overlapping the second hinge plate 253 and movable relative to the second hinge plate 253 when the first housing part 210 is rotated relative to the second housing part 220. A first width 441 of the thermal diffusion member 430 within the first heat dissipation member portion 531 in a direction perpendicular to a folding axis of the hinge assembly 250 may be greater than a second width 451 of the thermal diffusion member 430 within the second heat dissipation member portion 532 in the direction.

An area of the thermal diffusion member 430 within the first heat dissipation member portion 531 may be greater than an area of the thermal diffusion member 430 within the second heat dissipation member portion 532.

A shape of the thermal diffusion member 430 within the first heat dissipation member portion 531 may be different from a shape of the thermal diffusion member 430 within the second heat dissipation member portion 532.

The electronic device 101 may include a processor 120 disposed in the first housing part 210. The first hinge plate 252 may be closer to the first housing part 210 among the first housing part 210 and the second housing part 220.

The heat dissipation member 255 may be a first heat dissipation member 255. The foldable electronic device 101 may include a second heat dissipation member 311 disposed in the first housing part 210, physically spaced apart from the first heat dissipation member 255, and covering the processor.

The electronic device 101 may include a third heat dissipation member 312 disposed in the first housing part 210, physically spaced apart from the first heat dissipation member 255, and positioned between the first heat dissipation member 255 and the second heat dissipation member 311.

The heat dissipation member 255 may include the thermal diffusion member 430, a support member 410 covering a first surface of the thermal diffusion member 430, and a cushion member 440 covering a second surface of the thermal diffusion member 430 opposite to the first surface. The cushion member 440 may include a first cushion member portion 471 within the first heat dissipation member portion 531 and a second cushion member portion 472 within the second heat dissipation member portion 532. A first offset between the first width 441 and a third width 445 of the first cushion member portion 471 within the first heat dissipation member portion 531 in the direction may be less than a second offset between the second width 451 and a fourth width 455 of the second cushion member portion 472 within the second heat dissipation member portion 532 in the direction.

The thermal diffusion member 430 may be graphite or graphene.

The support member 410 may be positioned between the thermal diffusion member 430 and the flexible display 230, and the cushion member 440 may be positioned between the thermal diffusion member 430 and the hinge assembly 250.

A thickness of the thermal diffusion member 430 may be from 17 micrometers to 32 micrometers.

The heat dissipation member 255 may include the thermal diffusion member 430, the support member 410 covering the first surface of the thermal diffusion member 430, a first adhesive member 421 disposed between the thermal diffusion member 430 and the support member 410 and covering the first surface of the thermal diffusion member 430, the cushion member 440 covering the second surface of the thermal diffusion member 430 opposite to the first surface, and a second adhesive member 425 disposed between the thermal diffusion member 430 and the cushion member 440 and covering the second surface of the thermal diffusion member 430. A first offset 541 between the first width 441 and a third width 443 of the first adhesive member 421 within the first heat dissipation member portion 531 in the direction may be less than a second offset 551 between the second width 451 and a fourth width 453 of the first adhesive member within the second heat dissipation member portion 532 in the direction.

The second offset 551 may be equal to or less than twice the first offset 541.

The electronic device 101 may include a first adhesive member 841 or 842 attaching the first hinge plate 252 to the flexible display 230, and a second adhesive member 851, 853, or 855 attaching the second hinge plate 253 to the flexible display 230. An offset between a width in the direction of a portion of the first heat dissipation member portion 531 where the first adhesive member 841 or 842 is absent and a width of the first hinge plate 252 in the direction may be less than an offset between a width in the direction of a portion of the second heat dissipation member portion 532 where the second adhesive member 851, 853, or 855 is absent and a width of the second hinge plate 253 in the direction.

The number of the first adhesive member 841 or 842 may be less than the number of the second adhesive member 851, 853, or 855.

The first width 441 may indicate the greatest width of the thermal diffusion member 430 within the first heat dissipation member portion 531 in the direction, and the second width 451 may indicate the greatest width of the thermal diffusion member 430 within the second heat dissipation member portion 532 in the direction.

The electronic device 101 as described above may include a flexible display 230. The electronic device 101 may include a foldable housing 201 accommodating the flexible display 230. The foldable housing 201 may include a first housing part 210 and a second housing part 220. The electronic device 101 may include a hinge assembly 250 rotatably connecting each of the first housing part 210 and the second housing part 220. The hinge assembly 250 may include a first hinge plate 252 connected to the first housing part 210, a second hinge plate 253 connected to the second housing part 220, and a hinge module 254 rotatably connected to each of the first housing part 210 and the second housing part 220. The electronic device 101 may include a heat dissipation member 255 extending over the first hinge plate 252, the hinge module 254, and the second hinge plate 253. The heat dissipation member 255 may be adhesively fixed to the first hinge plate 252 and disposed in order not to be adhered to the second hinge plate 253.

The heat dissipation member 255 may include a first heat dissipation region 531 corresponding to the first hinge plate 252 and a second heat dissipation region 532 corresponding to the second hinge plate 253. The first heat dissipation region 531 may be at least partially fixed to the first hinge plate 252, and the second heat dissipation region 532 may be slid to the second hinge plate 253 as the foldable housing 201 is folded or unfolded.

A width of the first heat dissipation region 531 may be greater than a width of the second heat dissipation region 532.

The first heat dissipation region 531 and the second heat dissipation region 532 may have substantially different shapes when viewed in a direction substantially perpendicular to the flexible display 230.

The heat dissipation member 255 may include a heat conductive layer 430 (e.g., a thermal diffusion member) including a thermally conductive material. The heat conductive layer 430 may include a first heat conductive region corresponding to the first hinge plate 252 and a second heat conductive region corresponding to the second hinge plate 253. A width of the first heat conductive region may be greater than a width of the second heat conductive region.

The thermally conductive material may be graphite or graphene.

An in-plane thermal conductivity of the thermally conductive material may be equal to or more than 200 W/m·K.

The heat dissipation member 255 may further include a support layer 410 (e.g., a support member) disposed on a first surface of the heat conductive layer 430, and a cushion layer 440 (e.g., a cushion member) disposed on a second surface opposite to the first surface of the heat conductive layer 430.

The heat conductive layer 430 may less protrude in a direction perpendicular to a longitudinal direction of the heat dissipation member than each of the support layer 410 and the cushion layer 440 such that a side surface of the heat conductive layer 430 is recessed with respect to a side surface of the support layer 410 and a side surface of the cushion layer 440.

The cushion layer 440 may include a first side surface close to the first housing part 210 and a second side surface close to the second housing part 220. The heat dissipation member 255 may be formed such that a first offset between the first side surface and a third side surface close to the first housing part 210 of the first thermally conductive region is greater than a second offset between the second side surface and a fourth side surface close to the second housing part 220 of the second thermally conductive region.

The support layer 410 may be formed such that a side surface of the support layer 410 protrudes further in a direction perpendicular to a longitudinal direction of the heat dissipation member than a side surface of the cushion layer 440.

A thickness of the support layer 410 may be thicker than a thickness of the cushion layer 440.

The support layer 410 may include carbon fiber reinforced plastic (CFRP).

The heat dissipation member 255 may further include an additional cushion layer disposed on the support layer 410. A thickness of the additional cushion layer may be thinner than a thickness of the cushion layer 440.

The heat dissipation member 255 may be disposed to expose at least a portion of a periphery region of the second hinge plate 253 while the foldable housing 201 is fully unfolded.

The heat dissipation member 255 may have an extent smaller than an extent of the hinge assembly 250.

The heat dissipation member 255 may have a thickness of equal to or less than 160 µm.

In the electronic device 101, each of the first hinge plate 252 and the second hinge plate 253 may include at least one display fixed region 830 adhered to a portion of the flexible display 230. The heat dissipation member 255 may be formed not to overlap with the at least one display fixed region when viewed in a direction substantially perpendicular to the flexible display 230.

The first housing part 210 may accommodate a processor and the thermal diffusion member 430 disposed on the processor 120 to transfer some of heat generated from the processor 120 to the heat dissipation member 255.

The effects that can be obtained from the present disclosure are not limited to those described above, and any other effects not mentioned herein will be clearly understood by those having ordinary knowledge in the art to which the present disclosure belongs, from the following description.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

In a first example, there is provided a foldable electronic device (e.g. 101) comprising: a housing (e.g. 201) including a first housing part (e.g. 210) and a second housing part (e.g. 220), a flexible display (e.g. 230) disposed on the housing (e.g. 201), the flexible display (e.g. 230) including a bendable portion (e.g. 330) configured to bend when the first housing part (e.g. 210) is rotated relative to the second housing part (e.g. 220), a hinge assembly (e.g. 250) disposed under the flexible display (e.g. 230) and rotatably connecting the first housing part (e.g. 210) and the second housing part (e.g. 220) such that the first housing part (e.g. 210) is rotated relative to the second housing part (e.g. 220), the hinge assembly (e.g. 250) including: a first hinge plate (e.g. 252), and a second hinge plate (e.g. 253), with the first hinge plate (e.g. 252), configured to bend the bendable portion (e.g. 330) into a specified shape, and a heat dissipation member (e.g. 255) positioned between the bendable portion (e.g. 330) and the hinge assembly (e.g. 250), and including a thermal diffusion member (e.g. 430), the heat dissipation member (e.g. 255) comprising: a first heat dissipation member portion (e.g. 531) overlapping the first hinge plate (e.g. 252) and attached fixedly to the first hinge plate (e.g. 252), and a second heat dissipation member portion (e.g. 532) overlapping the second hinge plate (e.g. 253) and movable relative to the second hinge plate (e.g. 253) when the first housing part (e.g. 210) is rotated relative to the second housing part (e.g. 220), wherein the thermal diffusion member (430) includes a first thermal diffusion member portion (e.g. 431) corresponding to the first heat dissipation member portion (e.g. 531) and a second thermal diffusion member portion (e.g. 432) corresponding to the second heat dissipation member portion (e.g. 532), and wherein a first width (e.g. 441) of the first thermal diffusion member portion (e.g. 431) in a direction perpendicular to a folding axis of the hinge assembly (e.g. 250) is greater than a second width (e.g. 451) of the second thermal diffusion member portion (e.g. 432) in the direction.

In a second example, there is provided the foldable electronic device (e.g. 101) of the first example, wherein an area of the thermal diffusion member (e.g. 430) within the first heat dissipation member portion (e.g. 531) is greater than an area of the thermal diffusion member (e.g. 430) within the second heat dissipation member portion (e.g. 532).

In a third example, there is provided the foldable electronic device (e.g. 101) of the first example, wherein a shape of the thermal diffusion member (e.g. 430) within the first heat dissipation member portion (e.g. 531) is different from a shape of the thermal diffusion member (e.g. 430) within the second heat dissipation member portion (e.g. 532).

In a fourth example, there is provided the foldable electronic device (e.g. 101) of the first example, comprising: a processor (e.g. 120) disposed in the first housing part (e.g. 210), wherein the first hinge plate (e.g. 252) is closer to the first housing part (e.g. 210) among the first housing part (e.g. 210) and the second housing part (e.g. 220).

In a fifth example, there is provided the foldable electronic device (e.g. 101) of the fourth example, wherein the heat dissipation member (e.g. 255) is a first heat dissipation member (e.g. 255), and wherein the foldable electronic device (e.g. 101) comprises: a second heat dissipation member (e.g. 311) disposed in the first housing part (e.g. 210), physically spaced apart from the first heat dissipation member (e.g. 255), and covering the processor.

In a sixth example, there is provided the foldable electronic device (e.g. 101) of the fifth example, comprising: a third heat dissipation member (e.g. 312) disposed in the first housing part (e.g. 210), physically spaced apart from the first heat dissipation member (e.g. 255), and positioned between the first heat dissipation member (e.g. 255) and the second heat dissipation member (e.g. 311).

In a seventh example, there is provided the foldable electronic device (e.g. 101) of the first example, wherein the heat dissipation member (e.g. 255) comprises: the thermal diffusion member (e.g. 430); a support member (e.g. 410) covering a first surface of the thermal diffusion member (e.g. 430); and a cushion member (e.g. 440) covering a second surface of the thermal diffusion member (e.g. 430) opposite to the first surface, the cushion member (e.g. 440) including: a first cushion member portion (e.g. 471) corresponding to the first heat dissipation member portion (e.g. 531), and a second cushion member portion (e.g. 472) corresponding to the second heat dissipation member portion (e.g. 532), and wherein a first offset between a third width (e.g. 445) of the first cushion member portion (e.g. 471) in the direction and the first width (e.g. 441) is less than a second offset between a fourth width (e.g. 455) of the second cushion member portion (e.g. 472) in the direction and the second width (e.g. 451).

In an eighth example, there is provided the foldable electronic device (101) of the seventh example, wherein the thermal diffusion member (e.g. 430) is graphite or graphene.

In a ninth example, there is provided the foldable electronic device (e.g. 101) of the seventh example, wherein the support member (e.g. 410) is positioned between the thermal diffusion member (e.g. 430) and the flexible display (e.g. 230), and wherein the cushion member (e.g. 440) is positioned between the thermal diffusion member (e.g. 430) and the hinge assembly (e.g. 250).

In a tenth example, there is provided the foldable electronic device (101) of the seventh example, wherein a thickness of the thermal diffusion member (e.g. 430) is from 17 micrometers to 32 micrometers.

In an eleventh example, there is provided the foldable electronic device (e.g. 101) of the first example, wherein the heat dissipation member (e.g. 255) comprises: the thermal diffusion member (430); the support member (e.g. 410) covering the first surface of the thermal diffusion member (e.g. 430); a first adhesive member (e.g. 421) disposed between the thermal diffusion member (e.g. 430) and the support member (e.g. 410) and covering the first surface of the thermal diffusion member (e.g. 430); the cushion member (e.g. 440) covering the second surface of the thermal diffusion member (e.g. 430) opposite to the first surface; and a second adhesive member (e.g. 425) disposed between the thermal diffusion member (e.g. 430) and the cushion member (e.g. 440) and covering the second surface of the thermal diffusion member (e.g. 430), and wherein a first offset (e.g. 541) between the first width (e.g. 441) and a third width (e.g. 443) of the first adhesive member (e.g. 421) within the first heat dissipation member portion (e.g. 531) in the direction is less than a second offset (e.g. 551) between the second width (e.g. 451) and a fourth width (e.g. 453) of the first adhesive member within the second heat dissipation member portion (e.g. 532) in the direction.

In a twelfth example, there is provided the foldable electronic device (e.g. 101) of the eleventh example, wherein the second offset (e.g. 551) is equal to or less than twice the first offset (e.g. 541).

In a thirteenth example, there is provided the foldable electronic device (e.g. 101) of the first example, comprising: a first adhesive member (e.g. 841, 842) attaching the first hinge plate (e.g. 252) to the flexible display (e.g. 230); and a second adhesive member (e.g. 851, 853, 855) attaching the second hinge plate (e.g. 253) to the flexible display (e.g. 230), wherein an offset between a width in the direction of a portion of the first heat dissipation member portion (e.g. 531) where the first adhesive member (e.g. 841, 842) is absent and a width of the first hinge plate (e.g. 252) in the direction is less than an offset between a width in the direction of a portion of the second heat dissipation member portion (e.g. 532) where the second adhesive member (e.g. 851, 853, 855) is absent and a width of the second hinge plate (e.g. 253) in the direction.

In a fourteenth example, there is provided the foldable electronic device (e.g. 101) of the thirteenth example, wherein a number of the first adhesive member (e.g. 841, 842) is less than a number of the second adhesive member (e.g. 851, 853, 855).

In a fifteenth example, there is provided a portable electronic device (e.g. 101) comprising: a flexible display (e.g. 230); a foldable housing (e.g. 201) accommodating the flexible display (e.g. 230), the foldable housing (e.g. 201) comprising a first housing part (e.g. 210) and a second housing part (e.g. 220); a hinge assembly (e.g. 250) rotatably connecting each of the first housing part (e.g. 210) and the second housing part (e.g. 220), the hinge assembly (e.g. 250) comprising: a first hinge plate (e.g. 252) connected to the first housing part (e.g. 210), a second hinge plate (e.g. 253) connected to the second housing part (e.g. 220), and a hinge module (e.g. 254) rotatably connected to each of the first housing part (e.g. 210) and the second housing part (e.g. 220); and a heat dissipation member (e.g. 255) extending over the first hinge plate (e.g. 252), the hinge module (e.g. 254), and the second hinge plate (e.g. 253), wherein the heat dissipation member (e.g. 255) is adhesively fixed to the first hinge plate (e.g. 252) and disposed in order not to be adhered to the second hinge plate (e.g. 253).

In a sixteenth example, there is provided a foldable electronic device (e.g. 101) comprising: a housing (e.g. 201) including a first housing part (e.g. 210) and a second housing part (220), a flexible display (e.g. 230) disposed on the housing (e.g. 201), the flexible display (e.g. 230) including a bendable portion (e.g. 330) configured to bend when the first housing part (e.g. 210) is rotated relative to the second housing part (e.g. 220), a hinge assembly (e.g. 250) rotatably connecting the first housing part (e.g. 210) and the second housing part (e.g. 220), the hinge assembly (e.g. 250) comprising: a first hinge plate (e.g. 252) connected to the first housing part (e.g. 210), a second hinge plate (e.g. 253) connected to the second housing part (e.g. 220); and a heat dissipation member (e.g. 255) positioned between the bendable portion (e.g. 330) and the hinge assembly (e.g. 250), and including a thermal diffusion member (e.g. 430), the heat dissipation member (e.g. 255) comprising: a first heat dissipation member portion (e.g. 531) disposed to overlap the first hinge plate (e.g. 252), and a second heat dissipation member portion (e.g. 532) disposed to overlap the second hinge plate (e.g. 253), wherein the thermal diffusion member (e.g. 430) includes a first thermal diffusion member portion (e.g. 431) corresponding to the first heat dissipation member portion (e.g. 531) and a second thermal diffusion member portion (e.g. 432) corresponding to the second heat dissipation member portion (e.g. 532), and wherein a first width (e.g. 441) of the first thermal diffusion member portion (e.g. 431) in a direction perpendicular to a folding axis of the hinge assembly (e.g. 250) and parallel to the surface of the thermal diffusion member (e.g. 430) is greater than a second width (e.g. 451) of the second thermal diffusion member portion (e.g. 432) in the direction.

In a seventeenth example, there is provided the foldable electronic device (e.g. 101) of the sixteenth example, wherein the first heat dissipation member portion (e.g. 531) is attached fixedly to the first hinge plate (e.g. 252); and wherein the second heat dissipation member portion (e.g. 532) is movable relative to the second hinge plate (e.g. 253) when the first housing part (e.g. 210) is rotated relative to the second housing part (e.g. 220).

In a eighteenth example, there is provided the foldable electronic device (e.g. 101) of the sixteenth or seventeenth examples, wherein an area of the thermal diffusion member (e.g. 430) within the first heat dissipation member portion (e.g. 531) is greater than an area of the thermal diffusion member (e.g. 430) within the second heat dissipation member portion (e.g. 532).

In a nineteenth example, there is provided the foldable electronic device (e.g. 101) of any of the sixteenth to eighteenth examples, wherein a shape of the thermal diffusion member (e.g. 430) within the first heat dissipation member portion (e.g. 531) is different from a shape of the thermal diffusion member (e.g. 430) within the second heat dissipation member portion (e.g. 532).

In a twentieth example, there is provided the foldable electronic device (e.g. 101) of any of the sixteenth to nineteenth examples, comprising: a processor (e.g. 120) disposed in the first housing part (e.g. 210), wherein the first hinge plate (e.g. 252) is closer to the first housing part (e.g. 210) among the first housing part (e.g. 210) and the second housing part (e.g. 220).

In a twenty-first example, there is provided the foldable electronic device (e.g. 101) of the twentieth example, wherein the heat dissipation member (e.g. 255) is a first heat dissipation member (e.g. 255), and wherein the foldable electronic device (e.g. 101) comprises: a second heat dissipation member (e.g. 311) disposed in the first housing part (e.g. 210), physically spaced apart from the first heat dissipation member (e.g. 255), and covering the processor.

In a twenty-second example, there is provided the foldable electronic device (e.g. 101) of the twenty-first example, comprising: a third heat dissipation member (e.g. 312) disposed in the first housing part (e.g. 210), physically spaced apart from the first heat dissipation member (e.g. 255), and positioned between the first heat dissipation member (e.g. 255) and the second heat dissipation member (e.g. 311).

In a twenty-third example, there is provided the foldable electronic device (e.g. 101) of any of the sixteenth to twenty-second examples, wherein the heat dissipation member (e.g. 255) comprises: a support member (e.g. 410) covering a first surface of the thermal diffusion member (e.g. 430); and a cushion member (e.g. 440) covering a second surface of the thermal diffusion member (430) opposite to the first surface, the cushion member (e.g. 440) including: a first cushion member portion (e.g. 471) corresponding to the first heat dissipation member portion (e.g. 531), and a second cushion member portion (e.g. 472) corresponding to the second heat dissipation member portion (e.g. 532), and wherein a first offset between a third width (e.g. 445) of the first cushion member portion (e.g. 471) in the direction and the first width (e.g. 441) is less than a second offset between a fourth width (e.g. 455) of the second cushion member portion (e.g. 472) in the direction and the second width (e.g. 451).

In a twenty-fourth example, there is provided the foldable electronic device (e.g. 101) of the twenty-third example, wherein the support member (e.g. 410) is positioned between the thermal diffusion member (e.g. 430) and the flexible display (e.g. 230), and wherein the cushion member (e.g. 440) is positioned between the thermal diffusion member (e.g. 430) and the hinge assembly (e.g. 250).

In a twenty-fifth example, there is provided the foldable electronic device (e.g. 101) of any of the sixteenth to twenty-fourth examples, wherein the thermal diffusion member (e.g. 430) is graphite or graphene.

In a twenty-sixth example, there is provided the foldable electronic device (e.g. 101) of any of the sixteenth to twenty-fifth examples, wherein a thickness of the thermal diffusion member (e.g. 430) is from 17 micrometers to 32 micrometers.

In a twenty-seventh example, there is provided the foldable electronic device (e.g. 101) of any of the sixteenth to twenty-sixth examples, wherein the heat dissipation member (e.g. 255) comprises: a support member (e.g. 410) covering a first surface of the thermal diffusion member (e.g. 430); a first adhesive member (e.g. 421) disposed between the thermal diffusion member (e.g. 430) and the support member (e.g. 410) and covering the first surface of the thermal diffusion member (e.g. 430); a cushion member (e.g. 440) covering a second surface of the thermal diffusion member (e.g. 430) opposite to the first surface; and a second adhesive member (e.g. 425) disposed between the thermal diffusion member (e.g. 430) and the cushion member (e.g. 440) and covering the second surface of the thermal diffusion member (e.g. 430), and wherein a first offset (e.g. 541) between the first width (e.g. 441) and a third width (e.g. 443) of the first adhesive member (e.g. 421) within the first heat dissipation member portion (e.g. 531) in the direction is less than a second offset (e.g. 551) between the second width (e.g. 451) and a fourth width (e.g. 453) of the first adhesive member within the second heat dissipation member portion (e.g. 532) in the direction.

In a twenty-eighth example, there is provided the foldable electronic device (e.g. 101) of the twenty-seventh example, wherein the second offset (e.g. 551) is equal to twice the first offset (e.g. 541) or less than twice the first offset (e.g. 541).

In a twenty-ninth example, there is provided the foldable electronic device (e.g. 101) of any of the sixteenth to twenty-eighth examples, comprising: at least one first adhesive member (e.g. 841, 842) attaching the first hinge plate (e.g. 252) to the flexible display (e.g. 230); and at least one second adhesive member (e.g. 851, 853, 855) attaching the second hinge plate (e.g. 253) to the flexible display (e.g. 230), wherein an offset between a width, in the direction, of a portion of the first heat dissipation member portion (e.g. 531) where the at least one first adhesive member (e.g. 841, 842) is absent and a width, in the direction, of the first hinge plate (e.g. 252) is less than an offset between a width, in the direction, of a portion of the second heat dissipation member portion (e.g. 532) where the at least one second adhesive member (e.g. 851, 853, 855) is absent and a width, in the direction, of the second hinge plate (e.g. 253).

In a thirtieth example, there is provided the foldable electronic device (e.g. 101) of the twenty-ninth example, wherein a number of the at least one first adhesive member (e.g. 841, 842) is less than a number of the at least one second adhesive member (e.g. 851, 853, 855).

## Claims

1. A foldable electronic device (101) comprising:
a housing (201) including a first housing part (210) and a second housing part (220),
a flexible display (230) disposed on the housing (201), the flexible display (230) including a bendable portion (330) configured to bend when the first housing part (210) is rotated relative to the second housing part (220),
a hinge assembly (250) rotatably connecting the first housing part (210) and the second housing part (220), the hinge assembly (250) comprising:
a first hinge plate (252) connected to the first housing part (210),
a second hinge plate (253) connected to the second housing part (220); and a heat dissipation member (255) positioned between the bendable portion (330) and the hinge assembly (250), and including a thermal diffusion member (430), the heat dissipation member (255) comprising:
a first heat dissipation member portion (531) disposed to overlap the first hinge plate (252), and
a second heat dissipation member portion (532) disposed to overlap the second hinge plate (253),
wherein the thermal diffusion member (430) includes a first thermal diffusion member portion (431) corresponding to the first heat dissipation member portion (531) and a second thermal diffusion member portion (432) corresponding to the second heat dissipation member portion (532), and
wherein a first width (441) of the first thermal diffusion member portion (431) in a direction perpendicular to a folding axis of the hinge assembly (250) and parallel to the surface of the thermal diffusion member (430) is greater than a second width (451) of the second thermal diffusion member portion (432) in the direction.

2. The foldable electronic device (101) of claim 1, wherein the first heat dissipation member portion (531) is attached fixedly to the first hinge plate (252); and
wherein the second heat dissipation member portion (532) is movable relative to the second hinge plate (253) when the first housing part (210) is rotated relative to the second housing part (220).

3. The foldable electronic device (101) of claim 1 or 2,
wherein an area of the thermal diffusion member (430) within the first heat dissipation member portion (531) is greater than an area of the thermal diffusion member (430) within the second heat dissipation member portion (532).

4. The foldable electronic device (101) of any of claims 1 to 3,
wherein a shape of the thermal diffusion member (430) within the first heat dissipation member portion (531) is different from a shape of the thermal diffusion member (430) within the second heat dissipation member portion (532).

5. The foldable electronic device (101) of any of claims 1 to 4, comprising:
a processor (120) disposed in the first housing part (210),
wherein the first hinge plate (252) is closer to the first housing part (210) among the first housing part (210) and the second housing part (220).

6. The foldable electronic device (101) of claim 5,
wherein the heat dissipation member (255) is a first heat dissipation member (255), and
wherein the foldable electronic device (101) comprises:
a second heat dissipation member (311) disposed in the first housing part (210), physically spaced apart from the first heat dissipation member (255), and covering the processor.

7. The foldable electronic device (101) of claim 6, comprising:
a third heat dissipation member (312) disposed in the first housing part (210), physically spaced apart from the first heat dissipation member (255), and positioned between the first heat dissipation member (255) and the second heat dissipation member (311).

8. The foldable electronic device (101) of any of claims 1 to 7,
wherein the heat dissipation member (255) comprises:
a support member (410) covering a first surface of the thermal diffusion member (430); and
a cushion member (440) covering a second surface of the thermal diffusion member (430) opposite to the first surface, the cushion member (440) including:
a first cushion member portion (471) corresponding to the first heat dissipation member portion (531), and
a second cushion member portion (472) corresponding to the second heat dissipation member portion (532), and
wherein a first offset between a third width (445) of the first cushion member portion (471) in the direction and the first width (441) is less than a second offset between a fourth width (455) of the second cushion member portion (472) in the direction and the second width (451).

9. The foldable electronic device (101) of claim 8,
wherein the support member (410) is positioned between the thermal diffusion member (430) and the flexible display (230), and
wherein the cushion member (440) is positioned between the thermal diffusion member (430) and the hinge assembly (250).

10. The foldable electronic device (101) of any of claims 1 to 9,
wherein the thermal diffusion member (430) is graphite or graphene.

11. The foldable electronic device (101) of any of claims 1 to 10,
wherein a thickness of the thermal diffusion member (430) is from 17 micrometers to 32 micrometers.

12. The foldable electronic device (101) of any of claims 1 to 11,
wherein the heat dissipation member (255) comprises:
a support member (410) covering a first surface of the thermal diffusion member (430);
a first adhesive member (421) disposed between the thermal diffusion member (430) and the support member (410) and covering the first surface of the thermal diffusion member (430);
a cushion member (440) covering a second surface of the thermal diffusion member (430) opposite to the first surface; and
a second adhesive member (425) disposed between the thermal diffusion member (430) and the cushion member (440) and covering the second surface of the thermal diffusion member (430), and
wherein a first offset (541) between the first width (441) and a third width (443) of the first adhesive member (421) within the first heat dissipation member portion (531) in the direction is less than a second offset (551) between the second width (451) and a fourth width (453) of the first adhesive member within the second heat dissipation member portion (532) in the direction.

13. The foldable electronic device (101) of claim 12,
wherein the second offset (551) is equal to twice the first offset (541) or less than twice the first offset (541).

14. The foldable electronic device (101) of any of claims 1 to 13, comprising:
at least one first adhesive member (841, 842) attaching the first hinge plate (252) to the flexible display (230); and
at least one second adhesive member (851, 853, 855) attaching the second hinge plate (253) to the flexible display (230),
wherein an offset between a width, in the direction, of a portion of the first heat dissipation member portion (531) where the at least one first adhesive member (841, 842) is absent and a width, in the direction, of the first hinge plate (252) is less than an offset between a width, in the direction, of a portion of the second heat dissipation member portion (532) where the at least one second adhesive member (851, 853, 855) is absent and a width, in the direction, of the second hinge plate (253).

15. The foldable electronic device (101) of claim 14,
wherein a number of the at least one first adhesive member (841, 842) is less than a number of the at least one second adhesive member (851, 853, 855).
